(19) Europäisches Patentamt European Patent Office Office européen des brevets

(11) **EP 4 727 267 A1**

(12) **EUROPEAN PATENT APPLICATION**
published in accordance with Art. 153(4) EPC

(43) Date of publication:
**15.04.2026 Bulletin 2026/16**

(21) Application number: **24819427.6**

(22) Date of filing: **07.06.2024**

(51) International Patent Classification (IPC):
*H05K 1/11* (2006.01)    *H05K 1/02* (2006.01)
*H05K 3/40* (2006.01)    *H05K 3/42* (2006.01)

(52) Cooperative Patent Classification (CPC):
**H05K 1/02; H05K 1/11; H05K 3/40; H05K 3/42**

(86) International application number:
**PCT/JP2024/020939**

(87) International publication number:
**WO 2024/253200 (12.12.2024 Gazette 2024/50)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **09.06.2023 JP 2023095806**
**10.05.2024 JP 2024077561**

(71) Applicant: **Dai Nippon Printing Co., Ltd.**
**Tokyo 162-8001 (JP)**

(72) Inventors:
• **TAI Takahiro**
**Tokyo 162-8001 (JP)**
• **KURAMOCHI Satoru**
**Tokyo 162-8001 (JP)**
• **FUJIMOTO Koji**
**Tokyo 162-8001 (JP)**

(74) Representative: **Müller-Boré & Partner**
**Patentanwälte PartG mbB**
**Friedenheimer Brücke 21**
**80639 München (DE)**

(54) **THROUGH ELECTRODE SUBSTRATE, MOUNTING SUBSTRATE, AND METHOD FOR PRODUCING THROUGH ELECTRODE SUBSTRATE**

(57) A through via includes a closed portion that closes a through hole at least at a minimum portion of the through hole, a third portion that is located on a wall surface of the through hole between a first surface and the closed portion, and a fourth portion that is located on the wall surface of the through hole between a second surface and the closed portion. A resin layer includes a first resin layer that is located inside the third portion and a second resin layer that is located inside the fourth portion. The through via has a first distance that is a maximum value of a distance from the first surface to the closed portion in a thickness direction of a substrate and a second distance that is a maximum value of a distance from the second surface to the closed portion in the thickness direction of the substrate. A ratio of the first distance to a thickness of the substrate is 0.10 or more. A ratio of the second distance to the thickness of the substrate is 0.10 or more.

Fig. 3

## Description

Technical Field

An embodiment of the present disclosure relates to a through-via substrate and a method of manufacturing a through-via substrate.

Background Art

Through-via substrates are used in various applications. A through-via substrate is a member that includes a substrate including a first surface and a second surface, a through hole that is formed in the substrate, and a through via that is located in the through hole. For example, the through-via substrate is used as an interposer. The interposer is a member that is interposed between two electrical components. For example, the through-via substrate is interposed between two LSI chips in a thickness direction. In some cases, the through-via substrate is interposed between an element such as a LSI chip and a mounting substrate such as a motherboard. The through-via substrate is used also as a member that is included in a passive component such as an inductor or a capacitor.

For example, as disclosed in PTL 1, through vias of a through-via substrate have various structures. In a first example of a through via, a conductive material such as copper is entirely filled in a through hole. In a second example, a layer composed of a conductive material such as copper is formed on a wall surface of a through hole. In a third example, a layer composed of a conductive material such as copper is formed on a wall surface of a through hole, and a layer composed of a conductive material that closes the through hole is formed along the first surface or the second surface of the substrate. In the second example and the third example, a resin material is filled in a space in each through hole in which no conductive material is present.

Citation List

Patent Literature

PTL 1: International Publication No. 2022/173057

Summary of Invention

Technical Problem

There is a need to increase the maximum value of an electric current (also referred to below as an allowable current) that can flow into a through via. As for the through via in the first example, as the dimension of the through hole in a plane direction increases, the allowable current of the through via increases. However, as the dimension of the through hole increases, the conductive material that is filled in the through hole is likely to have a defect such as a void. Also as for the through vias in the second example and the third example, as the dimension of each through hole in the plane direction increases, the allowable current of the through via increases. As the dimension of each through hole increases, the resin material that is filled in the through hole is likely to have a defect such as a void.

An object of an embodiment of the present disclosure is to provide a through-via substrate and a method of manufacturing a through-via substrate that enable the problems to be effectively solved.

Solution to Problem

An embodiment of the present disclosure relates to [1] to [20] described below.

[1] A through-via substrate includes:

a substrate including a first surface, a second surface that is located opposite the first surface, and a through hole that extends from the first surface to the second surface;

a through via that is partly located in the through hole; and

a resin layer that is partly located in the through hole,

the through hole includes a wall surface including a first end that is connected to the first surface, a second end that is connected to the second surface, and a minimum portion that is located between the first end and the second end,

the through hole has a minimum dimension at the minimum portion, the minimum dimension being defined as a minimum value of a dimension of the through hole in a plane direction of the first surface,

the through via includes a closed portion that closes the through hole at least at the minimum portion, a third portion that is located on the wall surface between the first surface and the closed portion, and a fourth portion that is located on the wall surface between the second surface and the closed portion,

the resin layer includes a first resin layer that is located inside the third portion and a second resin layer that is located inside the fourth portion,

the through via has a first distance that is a maximum value of a distance from the first surface to the closed portion in a thickness direction of the substrate and a second distance that is a maximum value of a distance from the second surface to the closed portion in the thickness direction of the substrate,

a ratio of the first distance to a thickness of the substrate is 0.10 or more, and

a ratio of the second distance to the thickness of the substrate is 0.10 or more.

[2] As for the through-via substrate described in [1], the through via may include a first portion that is located on the first surface and that is connected to the third portion.

[3] As for the through-via substrate described in [2], the through via may include a second portion that is located on the second surface and that is connected to the fourth portion.

[4] The through-via substrate described in [1] may further include a first surface resin layer that is located on the first surface, and the first surface resin layer may overlap a boundary between the wall surface and the third portion in plan view.

[5] The through-via substrate described in [4] may further include a second surface resin layer that is located on the second surface, and the second surface resin layer may overlap a boundary between the wall surface and the fourth portion in plan view.

[6] As for the through-via substrate described in any one of [1] to [5], a ratio of a thickness of the closed portion to the thickness of the substrate may be 0.20 or more and 0.40 or less.

[7] As for the through-via substrate described in any one of [1] to [6], the through hole may have a first dimension at the first end and may have a second dimension at the second end in the plane direction of the first surface, a ratio of the first dimension to the minimum dimension may be 2.0 or more, and a ratio of the second dimension to the minimum dimension may be 2.0 or more.

[8] As for the through-via substrate described in [7], the ratio of the first dimension to the minimum dimension may be 3.0 or less, and the ratio of the second dimension to the minimum dimension may be 3.0 or less.

[9] As for the through-via substrate described in [7] or [8], a ratio of the second dimension to the first dimension may be 0.80 or more and 1.20 or less.

[10] As for the through-via substrate described in any one of [1] to [9], a ratio of a distance from the first surface to the minimum portion in the thickness direction of the substrate to the thickness of the substrate may be 0.40 or more and 0.60 or less.

[11] As for the through-via substrate described in [1] to [10], the minimum dimension may be 60 $\mu$m or more.

[12] As for the through-via substrate described in any one of [1] to [11], a ratio of the minimum dimension to a thickness of the third portion may be 1.2 or more, and a ratio of the minimum dimension to a thickness of the fourth portion may be 1.2 or more.

[13] As for the through-via substrate described in any one of [1] to [12], a ratio of the minimum dimension to a thickness of the third portion may be 3.0 or less, and a ratio of the minimum dimension to a thickness of the fourth portion may be 3.0 or less.

[14] As for the through-via substrate described in any one of [1] to [13], a thickness of the third portion and a thickness of the fourth portion may be 20 $\mu$m or more.

[15] As for the through-via substrate described in [14], a variation in the thickness of the third portion may be 0.10 $\mu$m or less.

[16] As for the through-via substrate described in any one of [1] to [15], the through via may include a seed layer and a plating layer that is located on the seed layer.

[17] As for the through-via substrate described in [16], the plating layer may contain copper.

[18] A mounting substrate includes:

the through-via substrate described in any one of [1] to [17]; and
an element that is electrically connected to the through via of the through-via substrate.

[19] A method of manufacturing a through-via substrate includes:

a step of preparing a substrate including a first surface, a second surface that is located opposite the first surface, and a through hole that extends from the first surface to the second surface;

a through via formation step of partly forming a through via in the through hole; and

a resin layer formation step of partly forming a resin layer in the through hole,

the through hole includes a wall surface including a first end that is connected to the first surface, a second end that is connected to the second surface, and a minimum portion that is located between the first end and the second end,

the through hole has a minimum dimension at the minimum portion, the minimum dimension being defined as a minimum value of a dimension of the through hole in a plane direction of the first surface,

the through via formation step includes a step of forming a seed layer on the wall surface of the through hole and a plating step of forming a plating layer on the seed layer,

the plating step includes a first plating step of forming a closed portion that closes the through hole at least at the minimum portion and a second plating step of growing the closed portion in a thickness direction of the substrate,

the through via has a first distance that is a maximum value of a distance from the first surface to the closed portion in the thickness direction of the substrate and a second distance that is a maximum value of a distance from the second surface to the closed portion in the thickness direction of the substrate, and

the second plating step ends in a state in which a ratio of the first distance to a thickness of the substrate is 0.10 or more, and a ratio of the second distance to the thickness of the substrate is 0.10 or more.

[20] In the method described in [19], the second plating step may be performed such that a ratio of a thickness of the closed portion to the thickness of the substrate is 0.20 or more and 0.40 or less.

Advantageous Effects of Invention

According to an embodiment of the present disclosure, the allowable current of a through via can be increased while a defect such as a void is inhibited from occurring.

Brief Description of Drawings

[Fig. 1] Fig. 1 is a sectional view of a through-via substrate according to an embodiment.

[Fig. 2] Fig. 2 is a sectional view of an example of a through hole of a substrate.

[Fig. 3] Fig. 3 is a sectional view of an example of a through via.

[Fig. 4] Fig. 4 is a sectional view of an example of a dimension of the through via.

[Fig. 5] Fig. 5 is a sectional view of an example of a step of preparing a substrate.

[Fig. 6] Fig. 6 is a sectional view of an example of a seed layer formation step.

[Fig. 7] Fig. 7 is a sectional view of an example of a plating layer formation step.

[Fig. 8] Fig. 8 is a sectional view of an example of the plating layer formation step.

[Fig. 9] Fig. 9 is a sectional view of an example of the plating layer formation step.

[Fig. 10] Fig. 10 is a sectional view of an example of a step of removing a portion of a seed layer.

[Fig. 11] Fig. 11 is a sectional view of an example of a resin layer formation step.

[Fig. 12] Fig. 12 is a sectional view of a through-via substrate according to a first comparative embodiment.

[Fig. 13] Fig. 13 is a sectional view of a through-via substrate according to a second comparative embodiment.

[Fig. 14] Fig. 14 is a sectional view of a through-via substrate according to a third comparative embodiment.

[Fig. 15] Fig. 15 is a sectional view of a through-via substrate according to a fourth comparative embodiment.

[Fig. 16] Fig. 16 is a sectional view of a through-via substrate according to a fifth comparative embodiment.

[Fig. 17] Fig. 17 is a sectional view of a through-via substrate according to a sixth comparative embodiment.

[Fig. 18] Fig. 18 is a sectional view of a modification to a through-via substrate.

[Fig. 19] Fig. 19 illustrates an example of a product on which a through-via substrate is mounted.

[Fig. 20] Fig. 20 is a table illustrating the result of evaluation in examples 1 to 12.

[Fig. 21] Fig. 21 is a table illustrating the result of evaluation in comparative examples 1 to 9.

[Fig. 22] Fig. 22 is a table illustrating the result of evaluation in examples 13 to 17.

[Fig. 23] Fig. 23 is a table illustrating the result of evaluation in comparative examples 10 to 12.

[Fig. 24] Fig. 24 is a sectional view of a modification to a through via.

[Fig. 25] Fig. 25 is a sectional view of an example of the seed layer formation step.

[Fig. 26] Fig. 26 is a sectional view of an example of the plating layer formation step.

[Fig. 27] Fig. 27 is a sectional view of an example of the resin layer formation step.

[Fig. 28] Fig. 28 is a sectional view of an example of a polishing step.

[Fig. 29] Fig. 29 is a sectional view of a modification to a through via.

[Fig. 30] Fig. 30 is a sectional view of an example of the polishing step.

[Fig. 31] Fig. 31 is a sectional view of an example of the resin layer formation step.

[Fig. 32] Fig. 32 is a sectional view of a modification to a through-via substrate.

[Fig. 33] Fig. 33 is a sectional view of a modification to a through-via substrate.

[Fig. 34] Fig. 34 is a plan view of a modification to a through-via substrate.

[Fig. 35] Fig. 35 is a sectional view of a modification to a through-via substrate.

[Fig. 36] Fig. 36 is a sectional view of an example of a step of forming a first surface resin layer and a second surface resin layer.

[Fig. 37] Fig. 37 is a sectional view of an example of a step of forming a conductive layer.

[Fig. 38] Fig. 38 is a sectional view of an example of the step of forming the conductive layer.

[Fig. 39] Fig. 39 is a sectional view of an example of the step of forming the conductive layer.

Description of Embodiments

The structure of a through-via substrate and a method of manufacturing the through-via substrate will be described in detail with reference to the drawings. Embodiments described later are examples of embodiments of the present disclosure, and the present disclosure is not interpreted so as to be limited to the embodiments. In the present specification, words such as a "substrate", a "base material", a "sheet", and a "film" are not distinguished from each other only based on different names. For example, the "substrate" has a concept that also involves a member that can be called a sheet or a film. A "surface" means a surface of a target plate member in a plane direction when the target plate member is overall and comprehensively viewed. A normal direction that is used for a plate member means a normal direction to a surface of the member. Words such as "parallel" and "perpendicular" and the values of a length and an angle that specify shapes, geometrical conditions, and the degree of these and that are used in the present specification, for example, are not limited by strict meaning but are interpreted to an extent that the same function can be expected.

In the case where multiple candidates of the upper limit and multiple candidates of the lower limit regarding a parameter are taken in the present specification, the numerical range of the parameter may include a combination of a freely selected one of the candidates of the upper limit and a freely selected one of the candidates of the lower limit. For example, the case of the description that "for example, a parameter B is A1 or more, may be A2 or more, or may be A3 or more. For example, the parameter B is A4 or less, may be A5 or less, or may be A6 or less" is considered. In this case, the numerical range of the parameter B may be A1 or more and A4 or less, may be A1 or more and A5 or less, may be A1 or more and A6 or less, may be A2 or more and A4 or less, may be A2 or more and A5 or less, may be A2 or more and A6 or less, may be A3 or more and A4 or less, may be A3 or more and A5 or less, or may be A3 or more and A6 or less.

In the drawings referred to according to the present embodiment, like portions or portions that have the same function are designated by like reference signs or similar reference signs, and a duplicated description for these is omitted in some cases. For convenience of description, the ratio of dimensions in the drawings differs from an actual ratio, and an illustration of a portion of a component is omitted in the drawings in some cases.

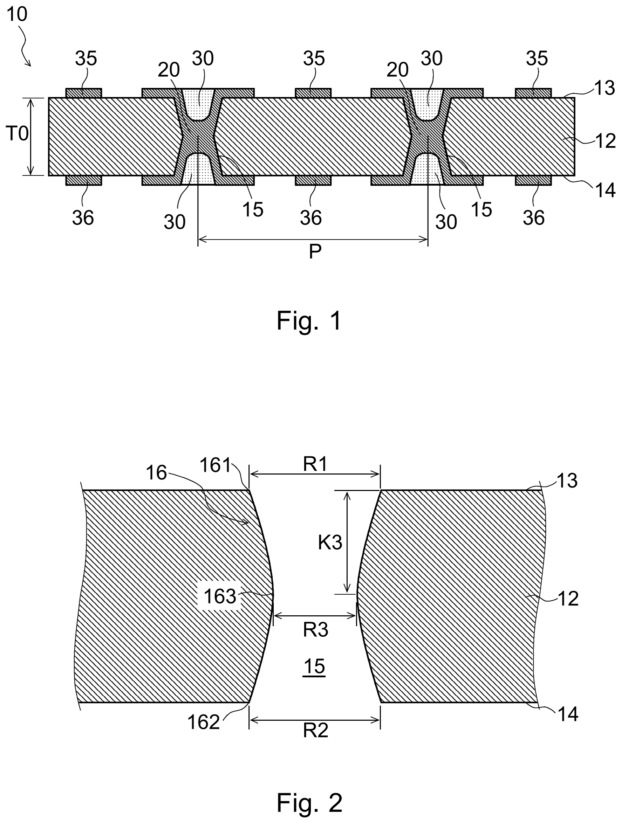

An embodiment of the present disclosure will be described. Fig. 1 is a sectional view of an example of a through-via substrate 10. The through-via substrate 10 includes a substrate 12, through vias 20, and a resin layer 30. The substrate 12 includes a first surface 13 and a second surface 14 that is located opposite the first surface 13. The substrate 12 further includes multiple through holes 15 that extend from the first surface 13 to the second surface 14. The through vias 20 and the resin layer 30 are located in the through holes 15. The through-via substrate 10 may include a first conductive layer 35 that is located on the first surface 13. The through-via substrate 10 may include a second conductive layer 36 that is located on the second surface 14.

(Substrate)

The substrate 12 contains an inorganic material that has insulation properties. For example, the substrate 12 is a glass substrate, a quartz substrate, a sapphire substrate, a resin substrate, a silicon substrate, a silicon carbide substrate, an alumina ($Al_2O_3$) substrate, an aluminum nitride (AlN) substrate, a zirconium oxide ($ZrO_2$) substrate or a substrate obtained by stacking these substrates. The substrate 12 may partly include a substrate composed of a conductive material such as an aluminum substrate or a stainless steel substrate.

An example of glass that is used for the substrate 12 is alkali-free glass. The alkali-free glass does not contain alkali components such as sodium and potassium. For example, the alkali-free glass contains boric acid instead of alkali components. For example, the alkali-free glass contains an alkaline earth metal oxide such as a calcium oxide or a barium oxide.

For example, the thickness T0 of the substrate 12 is 100 $\mu$m or more, may be 200 $\mu$m or more, or may be 300 $\mu$m or more. For example, the thickness T0 of the substrate 12 is 800 $\mu$m or less, may be 600 $\mu$m or less, or may be 400 $\mu$m or less.

The structure of the substrate 12 will be described. Fig. 2 is a sectional view of the substrate 12. In Fig. 2, the through vias 20 and the resin layer 30 are omitted. Each through hole 15 includes a wall surface 16 that extends from the first surface 13 to the second surface 14. The wall surface 16 includes a first end 161, a second end 162, and a minimum portion 163 that is located between the first end 161 and the second end 162.

The first end 161 is a portion of the wall surface 16 that is connected to the first surface 13. Each through hole 15 has a first dimension R1 in a plane direction of the first surface 13 at the first end 161. The second end 162 is a portion of the wall surface 16 that is connected to the second surface 14. Each through hole 15 has a second dimension R2 in the plane direction of the first surface 13 at the second end 162. Each through hole 15 has a minimum dimension R3 in the plane direction of the first surface 13 at the minimum portion 163. That is, the minimum portion 163 is defined as a portion of the wall surface 16 at which the dimension of each through hole 15 in the plane direction of the first surface 13 has the minimum value.

The first end 161, the second end 162, and the minimum portion 163 may have circular contours in plan view. In this case, the first dimension R1, the second dimension R2, and the minimum dimension R3 mean the diameters of the first end 161, the second end 162, and the minimum portion 163. The phrase "in plan view" means that an object is viewed in a normal direction to the first surface 13.

The minimum dimension R3 is smaller than the first dimension R1. The dimension of each through hole 15 may monotonically decrease from the first end 161 to the minimum portion 163. The minimum dimension R3 is smaller than the second dimension R2. The dimension of each through hole 15 may monotonically decrease from the second end 162 to the minimum portion 163.

For example, the minimum dimension R3 is 58 $\mu$m or more or may be 60 $\mu$m or more. When the minimum dimension R3 is 58 $\mu$m or more, the allowable current of the through vias 20 that are formed in the through holes 15 is sufficiently increased. For example, the minimum dimension R3 is 67 $\mu$m or less or may be 65 $\mu$m or less. When the minimum dimension R3 is 67 $\mu$m or less, a closed portion 25 described later is likely to be formed at the minimum portion 163.

For example, R1/R3 that is the ratio of the first dimension R1 to the minimum dimension R3 is 2.0 or more, may be 2.2 or more, or may be 2.5 or more. When the ratio R1/R3 is 2.0 or more, the allowable current of the through vias 20 that are formed in the through holes 15 is sufficiently increased. For example, the ratio R1/R3 is 3.2 or less, may be 3.0 or less, or may be 2.8 or less.

For example, R2/R3 that is the ratio of the second dimension R2 to the minimum dimension R3 is 2.0 or more, may be 2.2 or more, or may be 2.5 or more. When the ratio R2/R3 is 2.0 or more, the allowable current of the through vias 20 that are formed in the through holes 15 is sufficiently increased. For example, the ratio R2/R3 is 3.2 or less, may be 3.0 or less, or may be 2.8 or less. The ratio R2/R3 may be equal to or may differ from the ratio R1/R3.

A difference between the first dimension R1 and the second dimension R2 is preferably small. For example, R2/R1 that is the ratio of the second dimension R2 to the first dimension R1 is 0.8 or more or may be 0.9 or more. For example, the ratio R2/R1 is 1.2 or less or may be 1.1 or less. When the difference between the first dimension R1 and the second dimension R2 is small, the allowable current of the through vias 20 can be efficiently increased while a defect such as a void is inhibited from occurring.

As illustrated in Fig. 2, the minimum portion 163 may be located at the middle between the first surface 13 and the second surface 14 in the thickness direction of the substrate 12. In Fig. 2, a reference sign of K3 represents a distance from the first surface 13 to the minimum portion 163 in the thickness direction of the substrate 12. In the case where the minimum portion 163 is located at the middle between the first surface 13 and the second surface 14, K3/T0 that is the ratio of the distance K3 to the thickness T0 of the substrate is 0.50.

The position of the minimum portion 163 in the thickness direction of the substrate 12 may differ from the middle between the first surface 13 and the second surface 14 although this is not illustrated. That is, the ratio K3/T0 may differ from 0.50. For example, the ratio K3/TO is 0.40 or more or may be 0.45 or more. For example, the ratio K3/T0 is 0.60 or less or may be 0.55 or less.

(Through via)

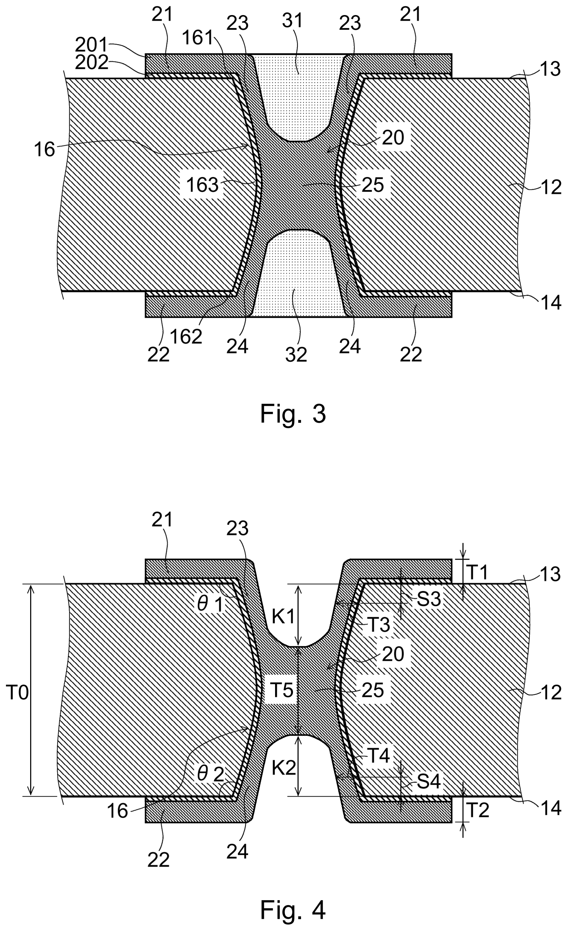

Fig. 3 is a sectional view of an example of the through vias 20. The through vias 20 are partly located in the through holes 15. The word "partly" means that the through vias 20 do not constitute the entire space of the through holes 15. The through vias 20 extend along the through holes 15 from the first surface 13 to the second surface 14.

The through vias 20 contain a conductive material. Each through via 20 includes at least a plating layer 201. The plating layer 201 is a conductive layer that is formed by using a plating method such as electroplating. Each through via 20 may include a seed layer 202. The seed layer 202 is located between a surface of the substrate 12 such as the first surface 13, the second surface 14, or the wall surface 16 and the plating layer 201. The seed layer 202 is a conductive layer that is formed by physical film formation such as sputtering.

The majority of each through via 20 is formed by the plating layer 201. For example, the ratio of the thickness of the plating layer 201 to the thickness of each through via 20 that is located on the wall surface 16 is 0.80 or more or may be 0.90 or more.

The plating layer 201 may contain metal such as copper, gold, silver, platinum, rhodium, tin, aluminum, nickel, titanium, chromium, or zinc, or an alloy of these. The seed layer 202 may contain a metal material such as copper, nickel, titanium, chromium, or zinc. The seed layer 202 may contain a compound of these metal materials.

Each through via 20 may include a first portion 21, a second portion 22, a third portion 23, a fourth portion 24, and the closed portion 25. The first portion 21 is located on the first surface 13. The second portion 22 is located on the second surface 14. The closed portion 25 is located on the minimum portion 163 of the wall surface 16 of the through hole 15. The closed portion 25 closes the through hole 15 at the minimum portion 163. The third portion 23 is located on the wall surface 16 between the first portion 21 and the closed portion 25. The third portion 23 is connected to the first portion 21 and the closed portion 25. The fourth portion 24 is located on the wall surface 16 between the second portion 22 and the closed portion 25. The fourth portion 24 is connected to the second portion 22 and the closed portion 25. The first portion 21, the second portion 22, the third portion 23, the fourth portion 24, and the closed portion 25 may include the plating layer 201 and the seed layer 202 described above.

The third portion 23 and the fourth portion 24 extend along the wall surface 16 of the through hole 15 so as to surround the center of the through hole 15 in plan view.

(Resin Layer)

The resin layer 30 is partly located in the through holes 15. The resin layer 30 is composed of a resin material that is filled in spaces of the through holes 15 in which the through vias 20 are not present. The resin layer 30 includes a first resin layer 31 that is located inside the third portion 23 of each through via 20 and a second resin layer 32 that is located inside the fourth portion 24 of each through via 20. The word "inside" means a direction toward the center of each through hole 15 in plan view.

The resin layer 30 contains a resin material that has insulation properties. Examples of the resin material include organic materials such as polyimide, epoxy, acryl, and polyphenyl ether.

The dimensions of components of the through vias 20 will be described with reference to Fig. 4. Fig. 4 is a sectional view of an example of the dimensions of the through vias 20. In Fig. 4, the resin layer 30 is omitted.

In Fig. 4, a reference sign of K1 represents the maximum value of the distance from the first surface 13 to the closed portion 25 in the thickness direction of the substrate 12. The distance K1 is also referred to as a first distance. A reference sign of K2 represents the maximum value of the distance from the second surface 14 to the closed portion 25 in the thickness direction of the substrate 12. The distance K2 is also referred to as a second distance. A reference sign of T5 represents the thickness of the closed portion 25. The thickness T5 is calculated by subtracting the first distance K1 and the second distance K2 from the thickness T0 of the substrate 12. That is, $T5 = T0 - (K1 + K2)$ is satisfied.

As the thickness T5 of each closed portion 25 increases, the allowable current of the through vias 20 increases. As the thickness T5 of the closed portion 25 increases, however, the plating layer 201 is likely to have a defect such as a void. In consideration of these points, the first distance K1 and the second distance K2 are preferably increased to a certain extent.

For example, K1/TO that is the ratio of the first distance K1 to the thickness T0 of the substrate 12 is 0.10 or more, may be 0.15 or more, or may be 0.20 or more. For example, the ratio K1/T0 is 0.40 or less, may be 0.35 or less, or may be 0.30 or less.

For example, K2/T0 that is the ratio of the second distance K2 to the thickness T0 of the substrate 12 is 0.10 or more, may be 0.15 or more, or may be 0.20 or more. For example, the ratio K2/T0 is 0.40 or less, may be 0.35 or less, or may be 0.30 or less. The ratio K2/T0 may be equal to or may differ from the ratio K1/T0.

For example, T5/T0 that is the ratio of the thickness T5 of each closed portion 25 to the thickness T0 of the substrate 12 is 0.20 or more or may be 0.25 or more. For example, the ratio T5/T0 is 0.40 or less or may be 0.35 or less.

A thermal cycle test of the through-via substrate 10 is conducted for evaluation of the reliability of the through-via substrate 10 as described in examples described later. In the thermal cycle test, the temperature of the through-via substrate 10 repeatedly increases or decreases. One thermal cycle includes a heating step, a high-temperature holding step, a cooling step, and a low-temperature holding step. For example, the thermal cycle test includes 1000 thermal cycles.

In the case where the thermal expansion coefficient of each through via 20 differs from the thermal expansion coefficient of the substrate 12, a change in the temperature of the through via 20 causes the through via 20 to expand or contract with respect to the substrate 12. The expansion or contraction causes stress to be applied between the substrate 12 and the through via 20. Stress due to a change in temperature is also referred to as thermal stress. It is thought that when each through via 20 expands or contracts, high thermal stress is applied to the first end 161 and the second end 162 of each through hole 15.

According to the present embodiment, the thickness T5 of each closed portion 25 that closes the through hole 15 is less than the thickness T0 of the substrate 12. That is, the through hole 15 is not closed by the through via 20 at the first end 161. In addition, the through hole 15 is not closed by the through via 20 at the second end 162. According to the present embodiment, the thermal stress at the first end 161 and the second end 162 is reduced unlike the case where the entire region of the through hole 15 is filled with the through via 20. Accordingly, the substrate 12 is inhibited from having a defect such as a crack.

In Fig. 4, a reference sign of θ1 represents an angle between the first surface 13 and the wall surface 16 at the first end 161. The angle θ1 may be larger than 90°. Since each through hole 15 includes the minimum portion 163, the angle θ1 can be larger than 90°. For example, the angle θ1 is 95° or more, may be 100° or more, or may be 105° or more. For example, the angle θ1 is 150° or less, may be 135° or less, or may be 120° or less.

In Fig. 4, a reference sign of θ2 represents an angle between the second surface 14 and the wall surface 16 at the second end 162. The angle θ2 may be larger than 90° as in the angle θ1. The numerical range of the angle θ2 may be equal to the numerical range related to the angle θ1 described above.

According to the present embodiment, each through hole 15 includes the minimum portion 163, and accordingly, the angle θ1 and the angle θ2 can be larger than 90°. When the angle θ1 and the angle θ2 are larger than 90°, the thermal stress at the first end 161 and the second end 162 can be reduced.

According to the present embodiment, the thermal stress at the first end 161 and the second end 162 is reduced, and accordingly, a distance between two through holes 15 adjacent to each other can be reduced unlike an existing through-via substrate. Accordingly, the first dimension R1 and the second dimension R2 of each through hole 15 can be increased, for example, while the same array pitch as that in the case of an existing through-via substrate is maintained. The increase in the first dimension R1 and the second dimension R2 enables the allowable current of the through vias 20 to be increased. According to the present embodiment, thermodynamic reliability and electrical characteristics can thus be improved.

As illustrated in Fig. 1, an array pitch P is a distance between the centers of two through holes 15 adjacent to each other. For example, R1/P that is the ratio of the first dimension R1 to the array pitch P is 0.1 or more or may be 0.2 or more. For example, R1/P is 0.5 or less or may be 0.4 or less.

In Fig. 4, a reference sign of T3 represents the thickness of the third portion 23 of each through via 20. The thickness T3 of the third portion 23 is specified at a position that is spaced from the first surface 13 by a distance S3 in the thickness direction of the substrate 12. The distance S3 is 50 μm. A reference sign of T4 represents the thickness of the fourth portion 24 of each through via 20. The thickness T4 of the fourth portion 24 is specified at a position that is spaced from the second surface 14 by a distance S4 in the thickness direction of the substrate 12. The distance S4 is 50 μm. The thickness T3 and the thickness T4 are dimensions of each through via 20 in the plane direction of the first surface 13.

As the thickness T3 and the thickness T4 increase, the allowable current of the through vias 20 increases. As the thickness T3 and the thickness T4 increase, however, the uniformity of the thickness of the third portion 23 and the thickness of the fourth portion 24 decreases.

For example, the thickness T3 and the thickness T4 are 20 μm or more, may be 25 μm or more, or may be 30 μm or more. For example, the thickness T3 and the thickness T4 are 50 μm or less, may be 40 μm or less, or may be 35 μm or less.

The upper limits of the thickness T3 and the thickness T4 are appropriately set, and consequently, the uniformity of the thickness of the third portion 23 and the thickness of the fourth portion 24 can be ensured.

The uniformity of the thickness of the third portion 23 is evaluated in a manner in which the thickness of the third portion 23 is measured at multiple positions in the thickness direction of the substrate 12. For example, in the case where a difference between the maximum value and the minimum value of the thickness T3, thickness T31, and thickness T32 of the third portion 23 is 0.10 μm or less, it is determined that a variation in the thickness of the third portion 23 is 0.10 μm or less. The thickness T3 is the thickness of the third portion 23 that is measured at a position that is spaced from the first surface 13 by the distance S3 in the thickness direction of the substrate 12. The thickness T31 is the thickness of the third portion 23 that is measured at a position that is spaced from the first surface 13 by (S3 + 20 $\mu$m) in the thickness direction of the substrate 12. The thickness T32 is the thickness of the third portion 23 that is measured at a position that is spaced from the first surface 13 by (S3 - 20 $\mu$m) in the thickness direction of the substrate 12.

The uniformity of the thickness of the fourth portion 24 is evaluated in a manner in which the thickness of the fourth portion 24 is measured at multiple positions in the thickness direction of the substrate 12 as in the case of the third portion 23. For example, in the case where a difference between the maximum value and the minimum value of the thickness T4, the thickness T41, and the thickness T42 of the fourth portion 24 is 0.10 $\mu$m or less, it is determined that a variation in the thickness of the fourth portion 24 is 0.10 $\mu$m or less. The thickness T4 is the thickness of the fourth portion 24 that is measured at a position that is spaced from the second surface 14 by the distance S4 in the thickness direction of the substrate 12. The thickness T41 is the thickness of the fourth portion 24 that is measured at a position that is spaced from the second surface 14 by (S4 + 20 $\mu$m) in the thickness direction of the substrate 12. The thickness T42 is the thickness of the fourth portion 24 that is measured at a position that is spaced from the second surface 14 by (S4 - 20 $\mu$m) in the thickness direction of the substrate 12.

For example, R3/T3 that is the ratio of the minimum dimension R3 to the thickness T3 of the third portion 23 is 1.2 or more, may be 1.5 or more, or may be 1.8 or more. When the ratio R3/T3 is 1.2 or more, the reliability of the through vias 20 can be improved. For example, the ratio R3/T3 is 3.0 or less, may be 2.4 or less, or may be 2.2 or less. When the ratio R3/T3 is 3.0 or less, the allowable current of the through vias 20 is sufficiently increased.

For example, R3/T4 that is the ratio of the minimum dimension R3 to the thickness T4 of the fourth portion 24 is 1.2 or more, may be 1.5 or more, or may be 1.8 or more as in the ratio R3/T3. For example, the ratio R3/T4 is 3.0 or less, may be 2.4 or less, or may be 2.2 or less as in the ratio R3/T3.

The first portion 21 that is located on the first surface 13 has a thickness T1. The thickness T1 of the first portion 21 may be equal to the thickness T3 of the third portion 23. The thickness T1 of the first portion 21 may be more than or less than the thickness T3 of the third portion 23.

The second portion 22 that is located on the second surface 14 has a thickness T2. The thickness T2 of the second portion 22 may be equal to the thickness T4 of the fourth portion 24. The thickness T2 of the second portion 22 may be more than or less than the thickness T4 of the fourth portion 24.

The distances and the dimensions described above regarding the substrate 12 and the through vias 20 are calculated based on an image of a section of the through-via substrate 10 that is obtained by an electron microscope. The section is obtained in a manner in which the through-via substrate 10 is cut along a cut surface that passes through the center of one of the through holes 15 in plan view.

(First Conductive Layer and Second Conductive Layer)

The first conductive layer 35 is a conductive layer that is located on the first surface 13. The first conductive layer 35 may be a pad or a wiring line. The first conductive layer 35 may include the plating layer 201 and the seed layer 202 as in the first portion 21 of each through via 20.

The second conductive layer 36 is a conductive layer that is located on the second surface 14. The second conductive layer 36 may be a pad or a wiring line. The second conductive layer 36 may include the plating layer 201 and the seed layer 202 as in the second portion 22 of each through via 20.

(Method of Manufacturing Through-via substrate)

An example of a method of manufacturing the through-via substrate 10 will now be described.

(Through Hole Formation Step)

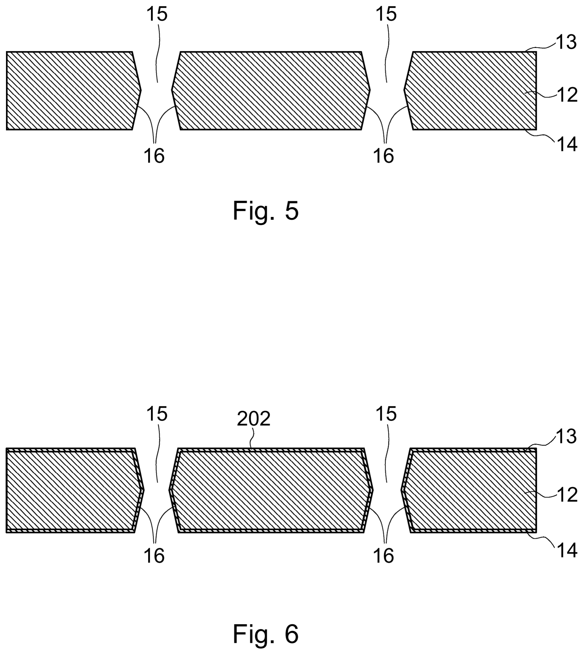

The substrate 12 is prepared. Subsequently, a resist layer is provided at least on the first surface 13 or the second surface 14. Subsequently, openings are provided at positions corresponding to the through holes 15 in the resist layer. Subsequently, the substrate 12 is processed at the openings in the resist layer. Consequently, as illustrated in Fig. 5, the through holes 15 are formed in the substrate 12. Each through hole 15 includes the wall surface 16 that extends from the first surface 13 to the second surface 14. Examples of a method of processing the substrate 12 can include a dry etching method or a wet etching method. Examples of the dry etching method include a reactive ion etching method and a deep reactive ion etching method.

The through holes 15 may be formed in the substrate 12 in a manner in which the substrate 12 is irradiated with a laser. In this case, the resist layer may not be provided. Examples of the laser can include an excimer laser, a Nd:YAG laser, and a femtosecond laser. In the case where the Nd:YAG laser is used, a fundamental wave that has a wavelength of 1064 nm, a second harmonic wave that has a wavelength of 532 nm, and a third harmonic wave that has a wavelength of 355 nm, for example, can be used.

The step of forming the through holes 15 in the substrate 12 may include a step of irradiating the first surface 13 and the second surface 14 of the substrate 12 with the layer and a wet etching step. In this case, the laser is not used to process the substrate 12 but is used to partly form modification layers of the first surface 13 and the second surface 14 of the substrate 12. At the wet etching step, the modification layers are etched in preference to other portions. As a result of wet etching, recessed portions are formed on the modification layer of the first surface 13, and recessed portions are formed on the modification layer of the second surface 14. The recessed portions of the first surface 13 and the recessed portions of the second surface 14 are connected to each other, and consequently, the through holes 15 that include the wall surfaces that extend from the first surface 13 to the second surface 14 are formed.

(Through Via Formation Step)

Subsequently, a through via formation step of forming the through vias 20 in the through holes 15 is performed. The through via formation step includes a seed layer formation step and a plating layer formation step.

At the seed layer formation step, as illustrated in Fig. 6, the seed layers 202 are formed on the wall surfaces 16 and the first surface 13 and the second surface 14 of the substrate 12. For example, the seed layers 202 are formed by sputtering.

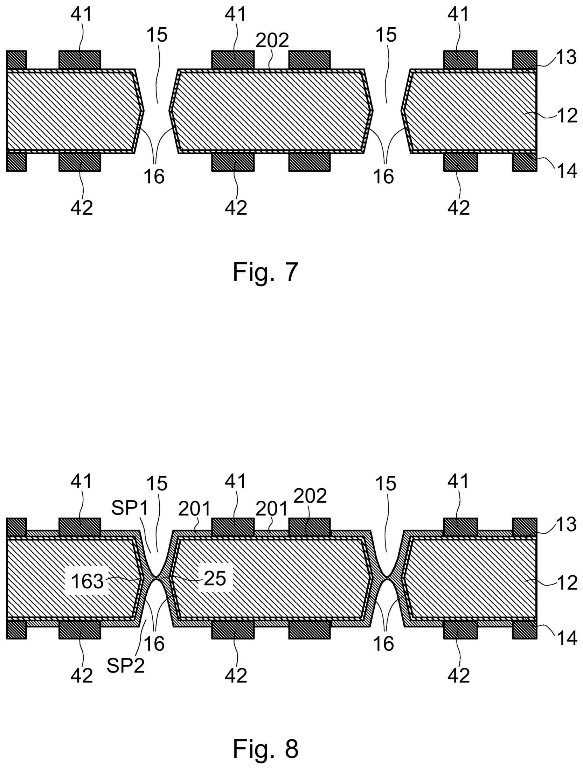

The plating layer formation step includes a resist layer formation step, a plating step, and a resist layer removal step. Fig. 7 is a sectional view of an example of the resist layer formation step. At the resist layer formation step, a first resist layer 41 is partly formed on the seed layers 202 that are located on the first surface 13, and a second resist layer 42 is partly formed on the seed layers 202 that are located on the second surface 14. The first resist layer 41 and the second resist layer 42 are provided so as to cover regions of the seed layers 202 in which the plating layers 201 are not formed.

Fig. 8 is a sectional view of an example of the plating step. At the plating step, the plating layers 201 are formed on the seed layers 202 by electroplating. For example, the substrate 12 that includes the seed layers 202 and the resist layers 41 and 42 may be immersed into an electroplating solution. An electric current is caused to flow into the seed layers 202, and consequently, the plating layers 201 are deposited on the seed layers 202.

The through holes 15 of the substrate 12 include the minimum portions 163. As the growth of the plating layers 201 progresses, portions of the plating layers 201 that are formed in the circumferential direction of the through holes 15 are connected to each other at the minimum portions 163. That is, as illustrated in Fig. 8, the through holes 15 are closed by the plating layers 201 at the minimum portions 163. That is, the closed portions 25 are formed. Subsequently, the electroplating solution circulates through first spaces SP1 and second spaces SP2 at the plating step. The first spaces SP1 are located between the minimum portions 163 and the first surface 13 in the thickness direction of the substrate 12. The second spaces SP2 are located between the minimum portions 163 and the second surface 14 in the thickness direction of the substrate 12.

A plating step before the through holes 15 are closed by the plating layers 201 at the minimum portions 163 is also referred to as a first plating step. A plating step after the through holes 15 are closed by the plating layers 201 at the minimum portions 163 is also referred to as a second plating step.

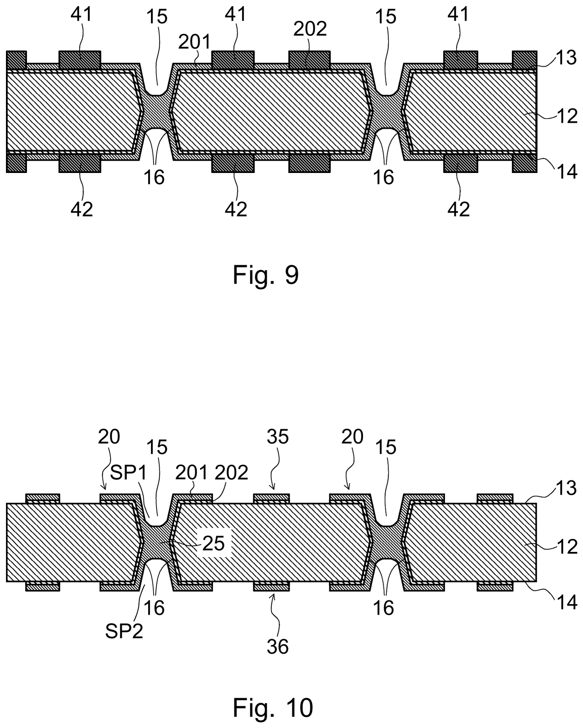

At the second plating step, the growth of the plating layers 201 progresses in the first spaces SP1 and the second spaces SP2. For example, as illustrated in Fig. 9, the closed portions 25 grow in the thickness direction of the substrate 12. The time of the second plating step is adjusted such that the numerical ranges regarding the first distance K1, the second distance K2, and the thickness T5 of each closed portion 25 described above, for example, are obtained. For example, the second plating step is performed such that the ratio of the thickness T5 of each closed portion 25 to the thickness T0 of the substrate 12 is 0.20 or more and 0.40 or less.

Subsequently, as illustrated in Fig. 10, a resist layer removal step of removing the first resist layer 41 and the second resist layer 42 is performed. Subsequently, a seed layer removal step of removing portions of the seed layers 202 is performed. At the seed layer removal step, as illustrated in Fig. 10, the portions of the seed layers 202 that overlapped the first resist layer 41 and the second resist layer 42 in plan view are removed. In this way, the through vias 20 are obtained.

(Resin Layer Formation Step)

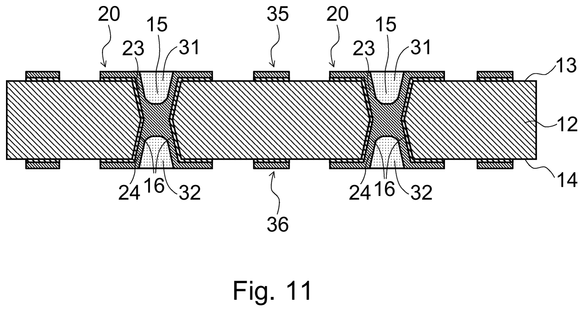

Subsequently, a resin layer formation step of forming the resin layer 30 is performed. For example, resin-material-containing layers are formed on the first surface 13 and on the second surface 14. For example, resin films that include resin-material-containing layers are attached on the first surface 13 and on the second surface 14. Subsequently, the resin-material-containing layer that is located on the first surface 13 is pushed into the inner space of each third portion 23. The resin-material-containing layer that is located on the second surface 14 is pushed into the inner space of each fourth portion 24. Subsequently, the resin material is hardened. For example, the resin-material-containing layers are irradiated with ultraviolet light. The resin material is hardened, and consequently, the first resin layers 31 and the second resin layers 32 are formed as illustrated in Fig. 11. In this way, the through-via substrate 10 that includes the substrate 12, the through vias 20, and the resin layer 30 is obtained.

As for the through-via substrate 10 according to the present embodiment, each through via 20 includes the first portion 21, the second portion 22, the third portion 23, the fourth portion 24, and the closed portion 25, and the resin layer 30 includes the first resin layers 31 and the second resin layers 32. With this structure, the allowable current of the through vias 20 can be increased while a defect such as a void is inhibited from occurring.

The advantages of the through-via substrate 10 according to the present embodiment will be described based on differences from comparative embodiments.

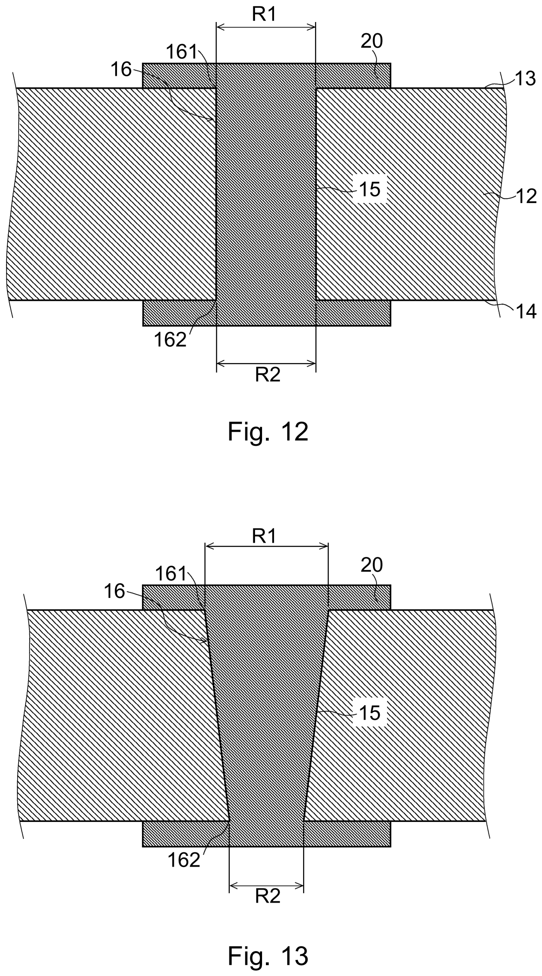

Fig. 12 is a sectional view of a through-via substrate according to a first comparative embodiment. According to the first comparative embodiment, a through via 20 is composed of a conductive material that is filled in an entire through hole 15. In this case, as a dimension of the through hole 15 in the plane direction of the first surface 13 increases, the allowable current of the through via 20 increases. According to the first comparative embodiment, the first dimension R1 and the second dimension R2 of the through hole 15 are set at large values. In this case, the allowable current is sufficiently increased. However, when a dimension of a plating layer in the plane direction of the first surface 13 is too large, this makes the plating layer likely to have a defect such as a void.

If the first dimension R1 and the second dimension R2 of the through hole 15 are limited, a defect such as a void is inhibited from occurring. If the first dimension R1 and the second dimension R2 are limited, however, the allowable current of the through via 20 is not sufficiently increased.

Fig. 13 is a sectional view of a through-via substrate according to a second comparative embodiment. According to the second comparative embodiment, a through via 20 is composed of a conductive material that is filled in an entire through hole 15 as in the first comparative embodiment. According to the second comparative embodiment, only the first dimension R1 of the through hole 15 is set at a large value.

According to the second comparative embodiment, there is a concern that as the first dimension R1 is too large, a plating layer is likely to have a defect such as a void as in the first comparative embodiment. If the first dimension R1 is limited to such an extent that the plating layer does not have a defect such as a void, a defect such as a void is inhibited from occurring. If the first dimension R1 is limited, however, the allowable current of the through via 20 is not sufficiently increased.

According to the present embodiment, the dimension of each plating layer in the plane direction of the first surface 13 is limited unlike the first comparative embodiment and the second comparative embodiment. For this reason, according to the present embodiment, the first dimension R1 and the second dimension R2 of each through hole 15 can be increased while a defect such as a void is inhibited from occurring. According to the present embodiment, the allowable current of the through vias 20 can be increased while a defect such as a void is inhibited from occurring.

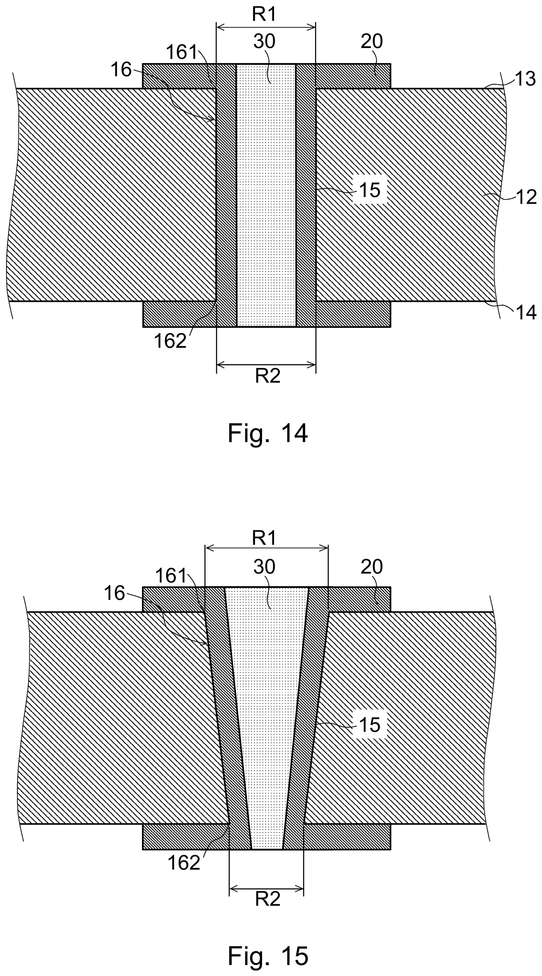

Fig. 14 is a sectional view of a through-via substrate according to a third comparative embodiment. According to the third comparative embodiment, a through via 20 includes a plating layer that is formed on a wall surface 16 of a through hole 15. A resin material is filled in a space in the through hole in which no plating layer is present.

According to the third comparative embodiment, the allowable current of the through via 20 is increased in a manner in which a dimension of the through hole 15 in the plane direction of the first surface 13 is set at a large value, or the thickness of the plating layer is set at a large value. According to the third comparative embodiment, the first dimension R1 and the second dimension R2 of the through hole 15 are set at large values, and the thickness of the plating layer is set at a large value. In this case, the allowable current is sufficiently increased. If the first dimension R1 and the second dimension R2 are set at large values, however, a space in the through hole in which no plating layer is present is enlarged. As a result, there is a concern that the resin material is likely to have a defect such as a void.

Fig. 15 is a sectional view of a through-via substrate according to a fourth comparative embodiment. According to the fourth comparative embodiment, a through via 20 includes a plating layer that is formed on a wall surface 16 of a through hole 15 as in the third comparative embodiment. A resin material is filled in a space in the through hole in which no plating layer is present. In the fourth comparative embodiment, only the first dimension R1 of the through hole 15 is set at a large value.

According to the fourth comparative embodiment, the second dimension R2 of the through hole 15 is small, and accordingly, the second end 162 of the through hole 15 is likely to be closed by the plating layer at a plating step. If the second end 162 is closed by the plating layer, the circulation of an electroplating solution in the through hole 15 is hindered. If the circulation of the plating solution is hindered, the thickness of the plating layer that is formed on the wall surface 16 of the through hole 15 is likely to vary depending on position.

According to the present embodiment, the closed portions 25 that close the through holes 15 are formed at the minimum portions 163 that are located between the first ends 161 and the second ends 162. According to the present embodiment, the size of the space in each through hole in which no plating layer is present is smaller than that according to the third comparative embodiment. According to the present embodiment, the resin layer 30 can accordingly be inhibited from having a defect such as a void. The closed portions 25 are not formed at the second ends 162 but are formed at the minimum portions 163, and accordingly, the dimensions of the spaces SP1 and SP2 through which the electroplating solution circulates in the thickness direction of the substrate 12 are smaller than those according to the fourth comparative embodiment. According to the present embodiment, the electroplating solution can accordingly circulate appropriately after the closed portions 25 are formed unlike the fourth comparative embodiment. According to the present embodiment, the thickness of the plating layer can accordingly be inhibited from varying depending on position.

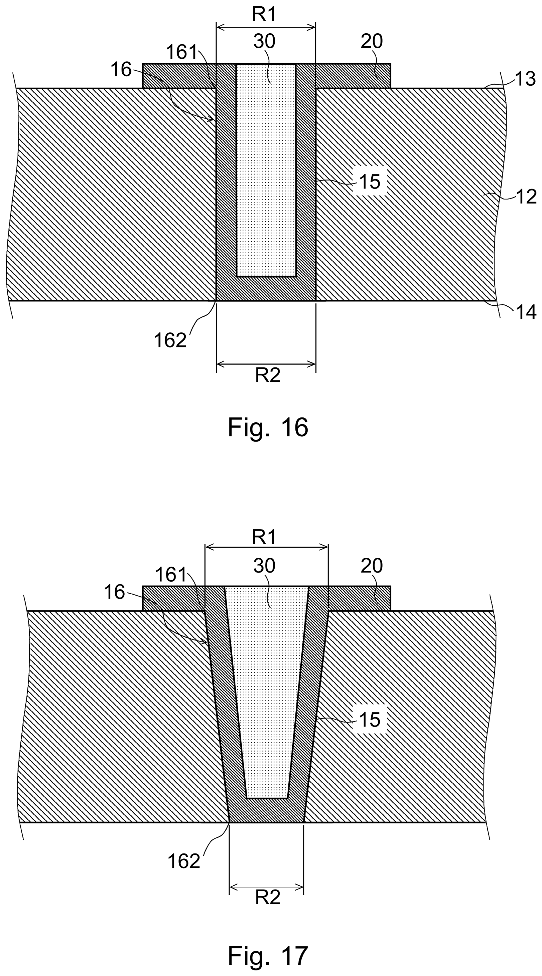

Fig. 16 is a sectional view of a through-via substrate according to a fifth comparative embodiment. According to the fifth comparative embodiment, a through via 20 includes a plating layer that is formed on a wall surface 16 of a through hole 15, and a plating layer that closes the through hole 15 at the second end 162. A resin material is filled in a space in the through hole in which no plating layer is present.

According to the fifth comparative embodiment, the allowable current of the through via 20 is increased in a manner in which a dimension of the through hole 15 in the plane direction of the first surface 13 is set at a large value or the thickness of the plating layer is set at a large value. According to the fifth comparative embodiment, the first dimension R1 and the second dimension R2 of the through hole 15 are set at large values, and the thickness of the plating layer is set at a large value. In this case, the allowable current is sufficiently increased. If the first dimension R1 and the second dimension R2 are set at large values, however, a space in the through hole in which no plating layer is present is enlarged. As a result, there is a concern that the resin material has a defect such as a void.

Fig. 17 is a sectional view of a through-via substrate according to a sixth comparative embodiment. According to the sixth comparative embodiment, a through via 20 includes a plating layer that is formed on a wall surface 16 of a through hole 15, and a plating layer that closes the through hole 15 at the second end 162 as in the fifth comparative embodiment. A resin material is filled in a space in the through hole in which no plating layer is present. According to the sixth comparative embodiment, only the first dimension R1 of the through hole 15 is set at a large value.

According to the sixth comparative embodiment, the second end 162 of the through hole 15 is closed by the plating layer at a plating step. If the second end 162 is closed by the plating layer, the circulation of an electroplating solution in the through hole 15 is hindered. If the circulation of the electroplating solution is hindered, the thickness of the plating layer that is formed on the wall surface 16 of the through hole 15 is likely to vary depending on position.

According to the present embodiment, the closed portions 25 that close the through holes 15 are formed at the minimum portions 163 that are located between the first ends 161 and the second ends 162. According to the present embodiment, the size of the space in each through hole in which no plating layer is present is smaller than that according to the sixth comparative embodiment. According to the present embodiment, the resin layer 30 can accordingly be inhibited from having a defect such as a void. The closed portions 25 are not formed at the second ends 162 but are formed at the minimum portions 163, and accordingly, the dimensions of the spaces SP1 and SP2 through which the electroplating solution circulates in the thickness direction of the substrate 12 are smaller than those according to the sixth comparative embodiment. According to the present embodiment, the electroplating solution can accordingly circulate appropriately after the closed portions 25 are formed unlike the sixth comparative embodiment. According to the present embodiment, the thickness of the plating layer can accordingly be inhibited from varying depending on position.

An embodiment described above can be modified in various ways. Modifications will now be described with reference to the drawings as needed. In the description below and the drawings that are used in the description below, as for a portion that can be the same as in an embodiment described above, the same reference sign as the reference sign that is used for a corresponding portion according to an embodiment described above is used. A duplicated description is omitted. In the case where the action and effect according to an embodiment described above are clearly achieved also according to a modification, the description thereof is omitted in some cases.

(First Modification)

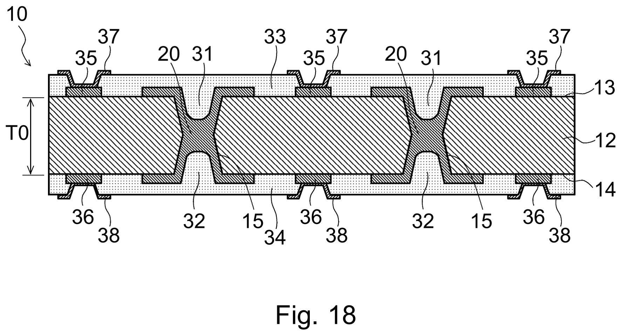

Fig. 18 is a sectional view of a through-via substrate 10 according to a first modification. The through-via substrate 10 may include a first surface resin layer 33 that is located on the first surface 13. The first surface resin layer 33 and the first resin layers 31 may be a single piece. For example, the first surface resin layer 33 and the first resin layers 31 may be formed by using the same resin film at the resin layer formation step. As illustrated in Fig. 18, a conductive layer 37 that is connected to the first conductive layer 35 may be formed in openings that are formed in the first surface resin layer 33.

The through-via substrate 10 may include a second surface resin layer 34 that is located on the second surface 14. The second surface resin layer 34 and the second resin layers 32 may be a single piece. For example, the second surface resin layer 34 and the second resin layers 32 may be formed by using the same resin film at the resin layer formation step. As illustrated in Fig. 18, a conductive layer 38 that is connected to the second conductive layer 36 may be formed in openings that are formed in the second surface resin layer 34.

(Second Modification)

A through-via substrate 10 may include a semiconductor element. The semiconductor element may include a terminal that is electrically connected to the conductive layer 37. The through-via substrate 10 on which the semiconductor element is mounted is also referred to as a mounting substrate.

(Third Modification)

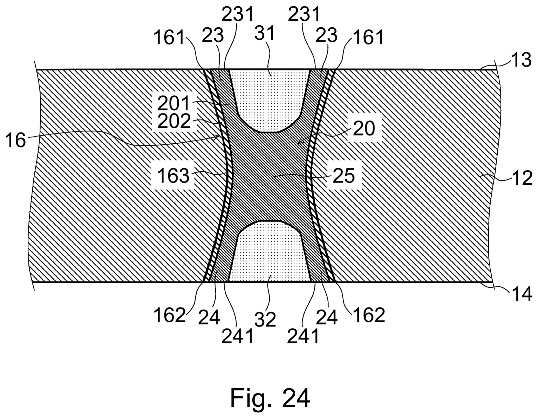

Fig. 24 is a sectional view of a through via 20 according to a third modification. The through via 20 includes at least the closed portion 25, the third portion 23, and the fourth portion 24. The closed portion 25 closes the through hole 15 at the minimum portion 163. The third portion 23 is located on the wall surface 16 between the first surface 13 and the closed portion 25. The fourth portion 24 is located on the wall surface 16 between the second surface 14 and the closed portion 25.

The through via 20 may not include the first portion 21. That is, the through via 20 may not include a portion that is located on the first surface 13. In this case, as illustrated in Fig. 24, the third portion 23 of the through via 20 may include an end surface parallel with the first surface 13. The end surface of the third portion 23 parallel with the first surface 13 is also referred to as a third surface 231. The third surface 231 may be flush with the first surface 13. The phrase "be flush with" means that a distance between two surfaces in the thickness direction of the substrate 12 is 1.0 $\mu$m or less.

The through via 20 may not include the second portion 22. That is, the through via 20 may not include a portion that is located on the second surface 14. In this case, as illustrated in Fig. 24, the fourth portion 24 of the through via 20 may include an end surface parallel with the second surface 14. The end surface of the fourth portion 24 parallel with the second surface 14 is also referred to as a fourth surface 241. The fourth surface 241 may be flush with the second surface 14.

A method of forming the through vias 20 will be described.

As illustrated in Fig. 5 described above, the through holes 15 are formed in the substrate 12. Subsequently, as illustrated in Fig. 6 described above, the seed layers 202 are formed on the wall surfaces 16 and the first surface 13 and the second surface 14 of the substrate 12.

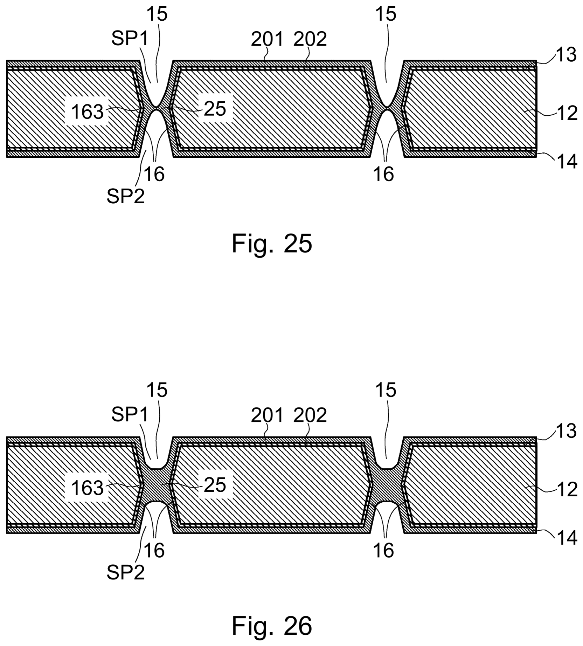

Subsequently, a plating step is performed. At the plating step, the plating layers 201 are formed on the seed layers 202 by electroplating. The plating layers 201 may be formed over the entire region of each of the seed layers 202. The plating step includes a first plating step illustrated in Fig. 25 and a second plating step illustrated in Fig. 26. At the second plating step, the numerical ranges regarding the first distance K1, the second distance K2, and the thickness T5 of each closed portion 25, for example, are adjusted.

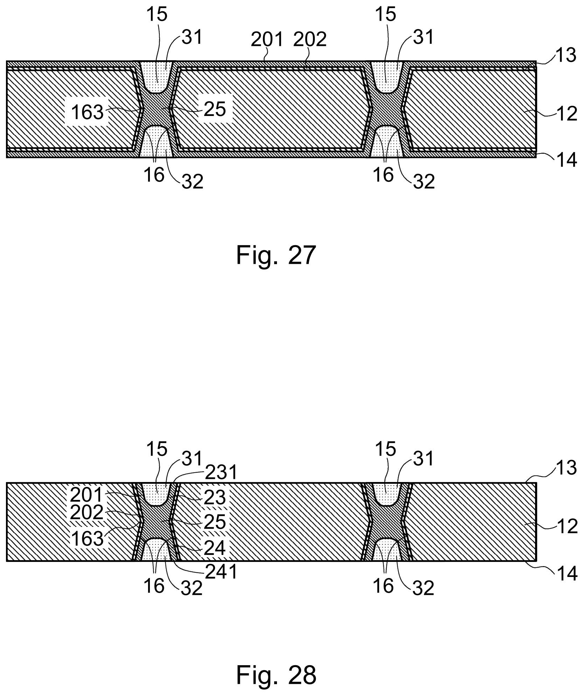

Subsequently, as illustrated in Fig. 27, the resin layer formation step may be performed. At the resin layer formation step, the first resin layers 31 are formed in the first spaces SP1, and the second resin layers 32 are formed in the second spaces SP2. The first resin layers 31 may be formed also on the plating layers 201 on the first surface 13 although this is not illustrated. The second resin layers 32 may be formed also on the plating layers 201 on the second surface 14 although this is not illustrated.

Subsequently, as illustrated in Fig. 28, a polishing step may be performed. The polishing step may include at least a first polishing step or a second polishing step. In an example illustrated in Fig. 28, the polishing step includes the first polishing step and the second polishing step. At the first polishing step, the seed layers 202 and the plating layers 201 that are located on the first surface 13 are removed by polishing. At the second polishing step, the seed layers 202 and the plating layers 201 that are located on the second surface 14 are removed by polishing. An example of the polishing is chemical mechanical polishing.

As a result of the first polishing step, the third surface 231 described above is formed at each third portion 23. As a result of the second polishing step, the fourth surface 241 described above is formed at each fourth portion 24.

According to the present modification, each through via 20 includes the third portion 23, the fourth portion 24, and the closed portion 25, and the resin layer 30 includes the first resin layers 31 and the second resin layers 32 as in the embodiment described above. According to the present modification, the dimension of each plating layer in the plane direction of the first surface 13 is limited as in the embodiment described above. Also according to the present modification, the first dimension R1 and the second dimension R2 of each through hole 15 can accordingly be increased while the resin layer 30 is inhibited from having a defect such as a void.

(Fourth Modification)

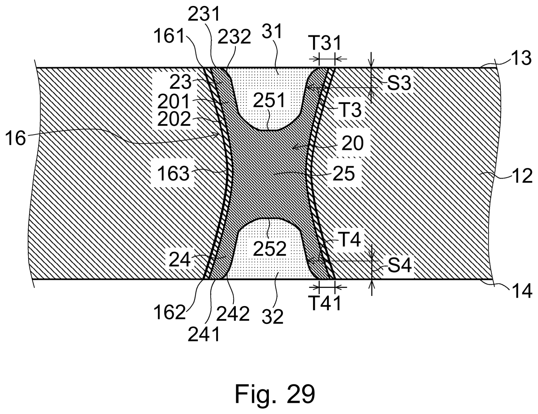

Fig. 29 is a sectional view of a through via 20 according to a fourth modification. The third portion 23 may include a curved surface 232 in sectional view. The curved surface 232 is in contact with the first resin layer 31. The curved surface 232 is connected to a surface of the third portion 23 parallel with the first surface 13. In an example illustrated in Fig. 29, the curved surface 232 is connected to the third surface 231. The curved surface 232 may have a normal direction parallel with the thickness direction of the substrate 12 at a position at which the curved surface 232 and the third surface 231 are connected to each other.

The advantages of the curved surface 232 will be described.

The through via 20 includes a surface that extends along the wall surface 16 and a surface parallel with the first surface 13. It is thought that if the directions in which the surfaces extend sharply change at a boundary portion between the two surfaces, the thermodynamic reliability or high-frequency electrical characteristics of the through via 20 decreases.

According to the present modification, a boundary portion between the surface of the third portion 23 that extends along the wall surface 16 and the third surface 231 corresponds to the curved surface 232. As for the curved surface 232, the direction in which the surface of the third portion 23 extends changes gently and continuously. According to the present modification, the thermodynamic reliability or high-frequency electrical characteristics of the through via 20 can accordingly be increased.

A reference sign of T31 represents the width of the third surface 231. The width T31 is a dimension of the third surface 231 in the in-plane direction of the first surface 13. The third portion 23 includes the curved surface 232, and accordingly, the width T31 is less than the thickness T3 of the third portion 23. For example, T31/T3 that is the ratio of the width T31 to the thickness T3 is 0.90 or less, may be 0.80 or less, or may be 0.70 or less. For example, T31/T3 is 0.10 or more, may be 0.30 or more, or may be 0.50 or more.

As illustrated in Fig. 29, the fourth portion 24 may include a curved surface 242 in sectional view. The curved surface 242 is in contact with the second resin layer 32. The curved surface 242 is connected to a surface of the fourth portion 24 parallel with the second surface 14. In an example illustrated in Fig. 29, the curved surface 242 is connected to the fourth surface 241. The curved surface 242 enables the thermodynamic reliability or high-frequency electrical characteristics of the through via 20 to be increased.

A reference sign of T41 represents the width of the fourth surface 241. The width T41 is a dimension of the fourth surface 241 in the in-plane direction of the second surface 14. The fourth portion 24 includes the curved surface 242, and accordingly, the width T41 is less than the thickness T4 of the fourth portion 24. The numerical range of T41/T4 that is the ratio of the width T41 to the thickness T4 may be equal to the numerical range described above regarding T31/T3.

A method of forming the through vias 20 will be described.

As illustrated in Fig. 5 described above, the through holes 15 are formed in the substrate 12. Subsequently, as illustrated in Fig. 6 described above, the seed layers 202 are formed on the wall surfaces 16 and the first surface 13 and the second surface 14 of the substrate 12. Subsequently, as illustrated in Fig. 25 and Fig. 26 described above, the plating step is performed.

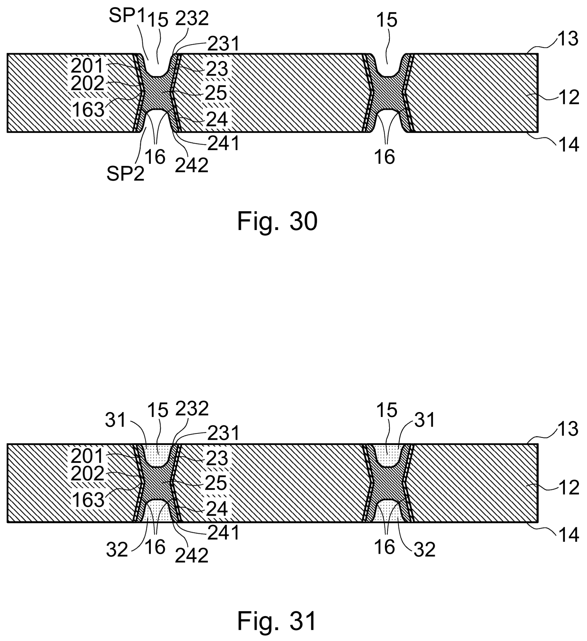

Subsequently, as illustrated in Fig. 30, the polishing step may be performed. The polishing step may include at least the first polishing step or the second polishing step. In an example illustrated in Fig. 30, the polishing step includes the first polishing step and the second polishing step. An example of the polishing is chemical mechanical polishing.

According to the present modification, the first polishing step may be performed before the first resin layers 31 are formed in the first spaces SP1. Since the first resin layers 31 have not yet been formed in the first spaces SP1, boundary portions between the surfaces of the third portions 23 that extend along the wall surfaces 16 and the third surfaces 231 are polished, and the curved surfaces 232 are formed.

According to the present modification, the second polishing step may be performed before the second resin layers 32 are formed in the second spaces SP2. Since the second resin layers 32 have not yet been formed in the second spaces SP2, boundary portions between the surfaces of the fourth portions 24 that extend along the wall surfaces 16 and the fourth surfaces 241 are polished, and the curved surfaces 242 are formed.

After the polishing step, as illustrated in Fig. 31, the resin layer formation step may be performed. At the resin layer formation step, the first resin layers 31 are formed in the first spaces SP1, and the second resin layers 32 are formed in the second spaces SP2.

According to the present modification, each through via 20 includes the third portion 23, the fourth portion 24, and the closed portion 25, and the resin layer 30 includes the first resin layers 31 and the second resin layers 32 as in the embodiment described above. According to the present modification, the dimension of each plating layer in the plane direction of the first surface 13 is limited as in the embodiment described above. Also according to the present modification, the first dimension R1 and the second dimension R2 of each through hole 15 can accordingly be increased while the resin layer 30 is inhibited from having a defect such as a void.

(Fifth Modification)

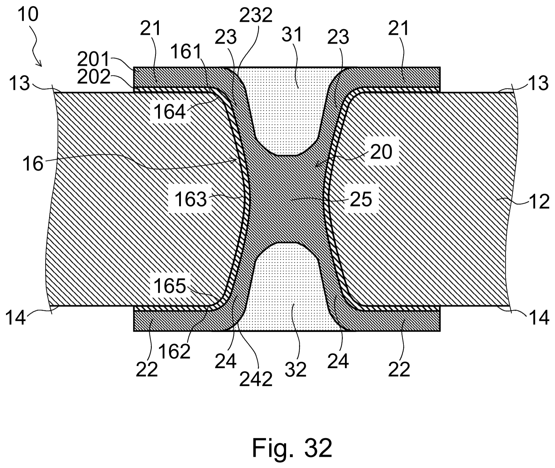

Fig. 32 is a sectional view of a through-via substrate 10 according to a fifth modification. A portion of the wall surface 16 of the through hole 15 may include a curved surface 164 in sectional view. The curved surface 164 is connected to the first end 161. The curved surface 164 may have a normal direction parallel with the thickness direction of the substrate 12 at the first end 161.

The advantages of the curved surface 164 will be described.

The substrate 12 includes the wall surface 16 and the first surface 13. It is thought that if the angles at which the surfaces extend sharply change at a boundary portion between the two surfaces, the thermodynamic reliability or high-frequency electrical characteristics of the through-via substrate 10 decreases.

According to the present modification, a portion of the wall surface 16 that is connected to the first surface 13 corresponds to the curved surface 164. As for the boundary portion between the first surface 13 and the wall surface 16, the angle at which a surface of the substrate 12 extends changes gently and continuously. According to the present modification, the thermodynamic reliability or high-frequency electrical characteristics of the through-via substrate 10 can accordingly be increased.

A surface of the third portion 23 has a shape that extends along the wall surface 16. The wall surface 16 includes the curved surface 164, and accordingly, the third portion 23 can also include the curved surface 232. According to the present modification, the curved surface 232 is connected to a surface of the first portion 21 parallel with the first surface 13. As for the curved surface 232, the direction in which the surface of the third portion 23 extends changes gently and continuously. According to the present modification, the thermodynamic reliability or high-frequency electrical characteristics of the through via 20 can accordingly be increased.

As illustrated in Fig. 32, a portion of the wall surface 16 of the through hole 15 may include a curved surface 165 that is connected to the second end 162 in sectional view. The curved surface 165 may have a normal direction parallel with the thickness direction of the substrate 12 at the second end 162.

The wall surface 16 includes the curved surface 165, and accordingly, the fourth portion 24 can also include the curved surface 242. According to the present modification, the curved surface 242 is connected to a surface of the second portion 22 parallel with the second surface 14. As for the curved surface 242, the direction in which a surface of the fourth portion 24 extends changes gently and continuously. According to the present modification, the thermodynamic reliability or high-frequency electrical characteristics of the through via 20 can accordingly be increased.

(Sixth Modification)

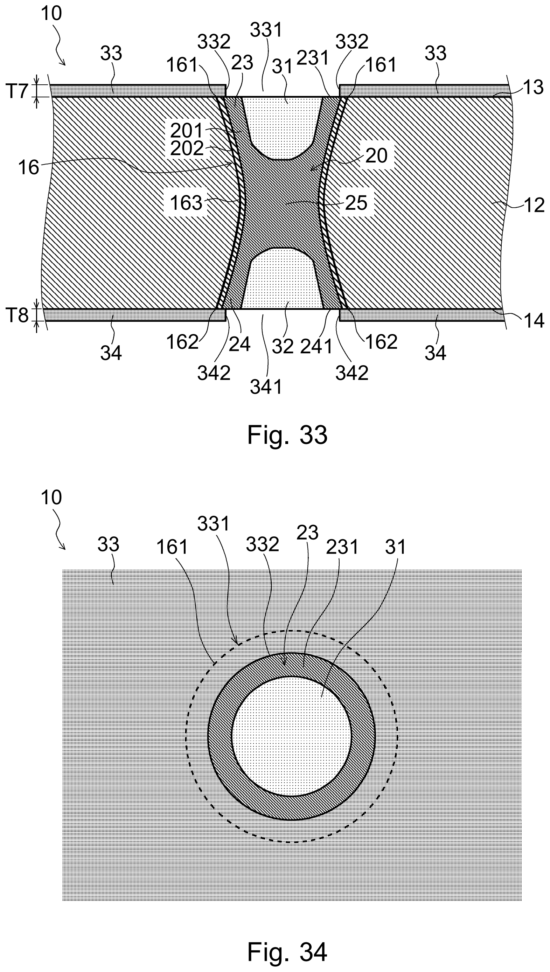

Fig. 33 is a sectional view of a through-via substrate 10 according to a sixth modification. Fig. 34 is a plan view of the through-via substrate 10 according to the sixth modification. The third portion 23 of the through via 20 includes the third surface 231 as in the case of the third modification and the fourth modification.

The through-via substrate 10 may include the first surface resin layer 33 that is located on the first surface 13. The first surface resin layer 33 may be in contact with the first surface 13.

The first surface resin layer 33 includes an opening 331 that extends through the first surface resin layer 33 and an opening end 332. The opening end 332 defines the contour of the opening 331 in plan view.

The first end 161 of the wall surface 16 defines the boundary between the wall surface 16 and the third portion 23 in plan view. The opening end 332 may be at least partly located inside the first end 161. In this case, the first surface resin layer 33 at least partly overlaps the boundary between the wall surface 16 and the third portion 23 in plan view.

As illustrated in Fig. 34, the entire region of the opening end 332 may be located inside the first end 161. In this case, the first surface resin layer 33 overlaps the entire region of the boundary between the wall surface 16 and the third portion 23 in plan view.

The first surface resin layer 33 does not overlap the entire region of the third surface 231. For example, as illustrated in Fig. 34, the opening end 332 may surround a portion of the third surface 231 in plan view. In this case, a portion of the third surface 231 that is located inside the opening end 332 is exposed to the opening 331. A conductive layer may be connected to the portion of the third surface 231 that is exposed to the opening 331 as described later.

The first surface resin layer 33 contains a resin material that has insulation properties. Examples of the resin material include organic materials such as polyimide, epoxy, acryl, and polyphenyl ether.

The first surface resin layer 33 has a thickness T7. For example, the thickness T7 is 1.0 $\mu$m or more, may be 2.0 $\mu$m or more, or may be 3.0 $\mu$m or more. For example, the thickness T7 is 20.0 $\mu$m or less, may be 15.0 $\mu$m or less, or may be 8.0 $\mu$m or less.

The fourth portion 24 of the through via 20 may include the fourth surface 241 as in the case of the third modification and the fourth modification. In this case, the through-via substrate 10 may include the second surface resin layer 34 that is located on the second surface 14. The second surface resin layer 34 may be in contact with the second surface 14.

The second surface resin layer 34 includes an opening 341 that extends through the second surface resin layer 34 and an opening end 342. The opening end 342 defines the contour of the opening 341 in plan view.

The opening end 342 may be at least partly located inside the second end 162. In this case, the second surface resin layer 34 at least partly overlaps the boundary between the wall surface 16 and the fourth portion 24 in plan view.

The entire region of the opening end 342 may be located inside the second end 162. In this case, the second surface resin layer 34 overlaps the entire region of the boundary between the wall surface 16 and the fourth portion 24 in plan view.

The second surface resin layer 34 does not overlap the entire region of the fourth surface 241. For example, the opening end 342 may surround a portion of the fourth surface 241 in plan view. In this case, a portion of the fourth surface 241 that is located inside the opening end 342 is exposed to the opening 341. A conductive layer may be connected to the portion of the fourth surface 241 that is exposed to the opening 341 as described later.

The second surface resin layer 34 contains a resin material that has insulation properties as in the first surface resin layer 33. The second surface resin layer 34 has a thickness T8. The numerical range of the thickness T8 may be equal to the numerical range described above regarding the thickness T7.

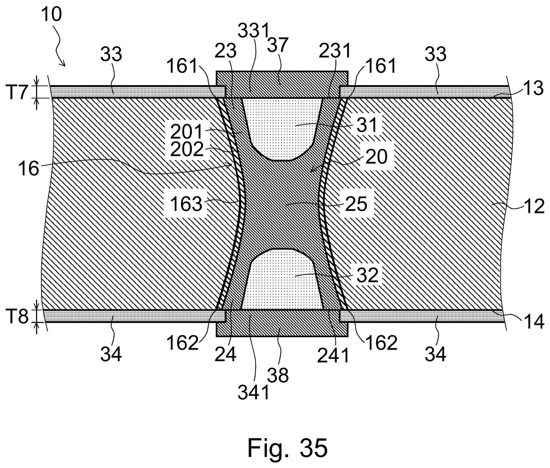

Fig. 35 is a sectional view of a modification to the through-via substrate 10. The through-via substrate 10 may include the conductive layer 37 that is located in the opening 331 of the first surface resin layer 33. The conductive layer 37 may be in contact with the third surface 231 of the third portion 23.

The conductive layer 37 may overlap the first resin layer 31 in plan view. The conductive layer 37 may not overlap the entire region of the first resin layer 31 in plan view although this is not illustrated.

The through-via substrate 10 may include the conductive layer 38 that is located in the opening 341 of the second surface resin layer 34. The conductive layer 38 may be in contact with the fourth surface 241 of the fourth portion 24.

The conductive layer 38 may overlap the second resin layer 32 in plan view. The conductive layer 38 may not overlap the entire region of the second resin layer 32 in plan view although this is not illustrated.

A method of manufacturing the through-via substrate 10 will be described.

A step of forming the through vias 20 each of which includes the third portion 23 that includes the third surface 231 is performed as in the case of the third modification and the fourth modification. Each through via 20 may include the fourth portion 24 that includes the fourth surface 241.

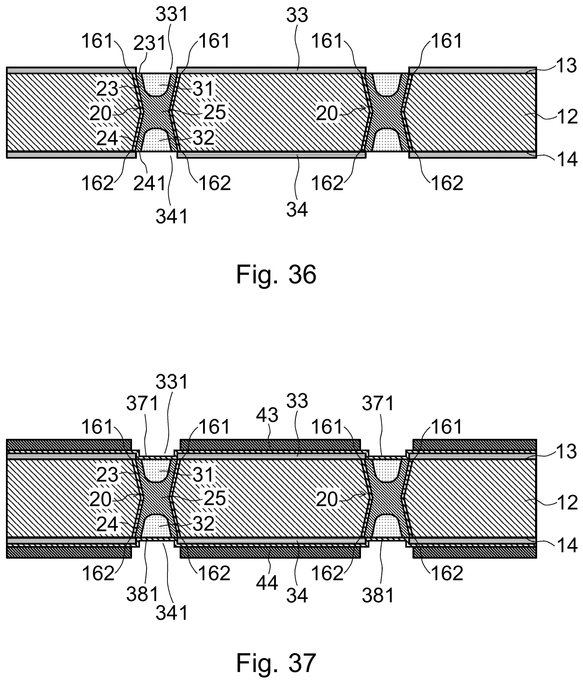

Subsequently, as illustrated in Fig. 36, a step of forming the first surface resin layer 33 on the first surface 13 is performed. For example, a solution that contains a resin material such as polyimide and a solvent is applied to the first surface 13. Subsequently, a drying step of evaporating the solvent is performed. Subsequently, a step of forming the openings 331 in the first surface resin layer 33 is performed. For example, in the case where the resin material is photosensitive, the openings 331 are formed in the first surface resin layer 33 by photolithography.

As illustrated in Fig. 36, the second surface resin layer 34 that includes the openings 341 may be formed on the second surface 14.

Subsequently, as illustrated in Fig. 37, a seed layer 371 is formed in the openings 331 of the first surface resin layer 33. For example, the seed layer 371 is formed by sputtering. The seed layer 371 is in contact with the third surface 231 of each third portion 23. The seed layer 371 may be formed also on the first surface resin layer 33.

As illustrated in Fig. 37, a seed layer 381 may be formed in the openings 341 of the second surface resin layer 34 and on the second surface resin layer 34.

Subsequently, as illustrated in Fig. 37, a resist layer 43 is formed on the seed layer 371. The resist layer 43 is provided so as to cover regions of the seed layer 371 except for regions corresponding to the conductive layer 37.

As illustrated in Fig. 37, a resist layer 44 may be formed on the seed layer 381. The resist layer 44 is provided so as to cover regions of the seed layer 381 except for regions corresponding to the conductive layer 38.

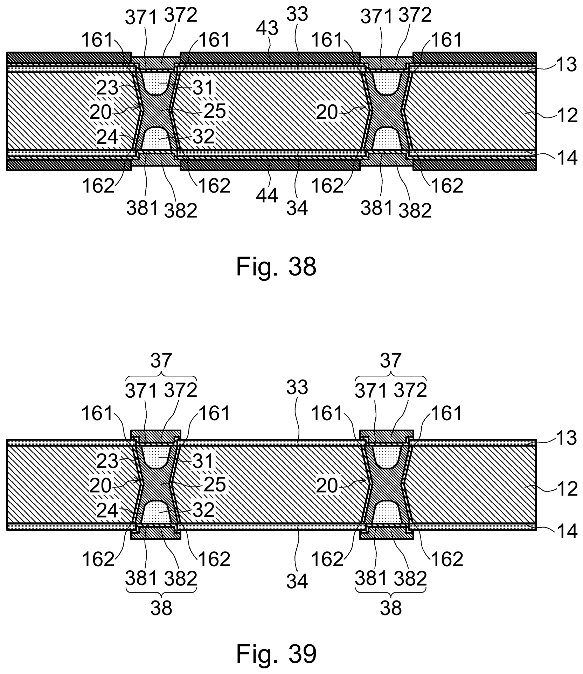

Subsequently, as illustrated in Fig. 38, a plating layer 372 is formed on the seed layer 371 by electroplating.

As illustrated in Fig. 38, a plating layer 382 may be formed on the seed layer 381 by electroplating.

Subsequently, as illustrated in Fig. 39, the resist layer 43 is removed. Subsequently, the seed layer 371 that overlapped the resist layer 43 in plan view is removed. The conductive layer 37 that includes the seed layer 371 and the plating layer 372 and that is connected to each third portion 23 is obtained.

As illustrated in Fig. 39, the resist layer 44 may be removed. Subsequently, the seed layer 381 that overlapped the resist layer 44 in plan view may be removed. The conductive layer 38 that includes the seed layer 381 and the plating layer 382 and that is connected to each fourth portion 24 is obtained.

In some cases, gas is generated at the step of manufacturing the through-via substrate 10. For example, the gas is generated from the through vias 20. For example, the gas is generated from the resin material such as the resin layer 30. For example, the gas is water vapor. For example, the gas is generated at a step of heating a component of the through-via substrate 10.

The gas remains in a gap in the through-via substrate 10. For example, the gas remains in gaps between the wall surfaces 16 and the through vias 20. If the gas continues remaining in the gap in the through-via substrate 10, there is a concern that an inner portion of the through-via substrate 10 deforms or is damaged due to the pressure of the gas.

According to the present modification, the through-via substrate 10 includes the first surface resin layer 33 that overlaps the boundaries between the wall surfaces 16 and the third portions 23. The molecular structure of the resin material of which the first surface resin layer 33 is composed is larger than the molecular structure of the gas such as water vapor. The gas in the gaps between the wall surfaces 16 and the third portions 23 passes through the first surface resin layer 33 and is discharged to a location outside the through-via substrate 10. Accordingly, an inner portion of the through-via substrate 10 is inhibited from deforming and from being damaged.

The molecular structure of the resin material of which the second surface resin layer 34 is composed is larger than the molecular structure of the gas such as water vapor as in the case of the first surface resin layer 33. The gas in the gaps between the wall surfaces 16 and the fourth portions 24 passes through the second surface resin layer 34 and is discharged to a location outside the through-via substrate 10. Accordingly, an inner portion of the through-via substrate 10 is inhibited from deforming and from being damaged.

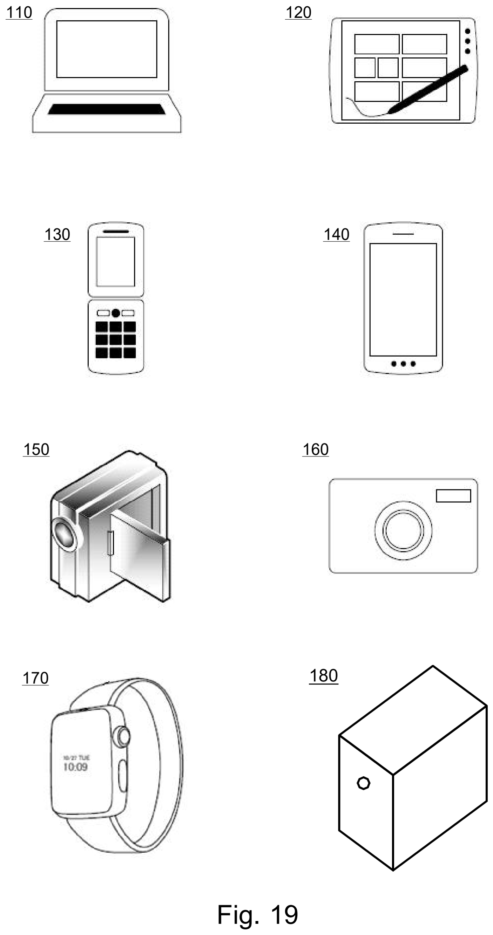

Fig. 19 illustrates an example of a product on which the through-via substrate 10 is mounted. The through-via substrate 10 can be used for various products. For example, the through-via substrate 10 is mounted on a notebook personal computer 110, a tablet terminal 120, a mobile phone 130, a smart phone 140, a digital video camera 150, a digital camera 160, a digital clock 170, or a server 180.

The modifications to the embodiment described above are described above, and multiple modifications that are appropriately combined can be naturally used for the embodiment described above.

**EXAMPLES**

The embodiment of the present disclosure will now be described in more detail by using examples, but the embodiment of the present disclosure is not limited to the examples described below without departing from the spirit thereof.

(EXAMPLE 1)

A glass substrate that has a thickness T0 of 400 $\mu$m was prepared as the substrate 12. Subsequently, the through holes 15 were formed in the substrate 12. Each through hole 15 included the first end 161 that had the first dimension R1, the second end 162 that had the second dimension R2, and the minimum portion 163 that had the minimum dimension R3. The first end 161, the second end 162, and the minimum portion 163 had a circular contour in plan view. The first dimension R1, the second dimension R2, and the minimum dimension R3 were 150 $\mu$m, 150 $\mu$m, and 60 $\mu$m.

Subsequently, the through vias 20 that included the seed layer 202 and the plating layer 201 composed of copper were formed in the through holes 15. Each through via 20 included the first portion 21, the second portion 22, the third portion 23, the fourth portion 24, and the closed portion 25. The thickness T3 of the third portion 23 and the thickness T4 of the fourth portion 24 were 30 $\mu$m. The distance from the first surface 13 to the closed portion 25 in the thickness direction of the substrate 12, that is, the first distance K1 was 150 $\mu$m. The distance from the second surface 14 to the closed portion 25 in the thickness direction of the substrate 12, that is, the second distance K2 was 150 $\mu$m. The thickness T5 of the closed portion 25 in the thickness direction of the substrate 12 was 100 $\mu$m.

K1/T0 that is the ratio of the first distance K1 to the thickness T0 of the substrate 12 was 0.375. K2/T0 that is the ratio of the second distance K2 to the thickness T0 of the substrate 12 was 0.375. T5/TO that is the ratio of the thickness T5 of the closed portion 25 to the thickness T0 of the substrate 12 was 0.25.

The maximum value of an electric current that can flow into the through vias 20 of the through-via substrate 10 in an example 1 was measured. The maximum value of the electric current is also referred to as the allowable current. The allowable current was 0.90 A.

The allowable current is defined as a value of an electric current that causes the temperature of each through via 20 to increase by 10°C. The increase in the temperature is a difference between the temperature of the through via 20 when no electric current flows and the temperature of the through via 20 when the allowable current flows. In the example 1, examples 2 to 17, and comparative examples 1 to 12 described later, the allowable current was calculated in a manner in which the temperature of the through via 20 was measured while the value of the electric current that flowed into the through via 20 was changed. The temperature of the through via 20 was measured 10 minutes after the value of the electric current was changed. A device that caused the electric current to flow into the through via 20 was I-V meter SPST-A1A made by Togami Electric Mfg. Co., Ltd. A device that measured the temperature of the through via 20 was a thermographic device. A infrared camera, Optris PI 450, was used as the thermographic device.

The reliability of the through-via substrate 10 in the example 1 was evaluated. The reliability was evaluated by observing the appearance of the through-via substrate 10 after the through-via substrate 10 was subjected to 1000 thermal cycles. The appearance of the through vias 20 of the through-via substrate 10 did not have a defect such as a crack. One thermal cycle included a heating step, a high-temperature holding step, a cooling step, and a low-temperature holding step. At the heating step, the surrounding environment of the through-via substrate 10 was changed from -55°C to +125°C for 30 minutes. At the high-temperature holding step, the surrounding environment of the through-via substrate 10 was maintained at +125°C for 30 minutes. At the heating step, the surrounding environment of the through-via substrate 10 was changed from +125°C to -55°C for 30 minutes. At the low-temperature holding step, the surrounding environment of the through-via substrate 10 was maintained at -55°C for 30 minutes.

(EXAMPLES 2 to 12)

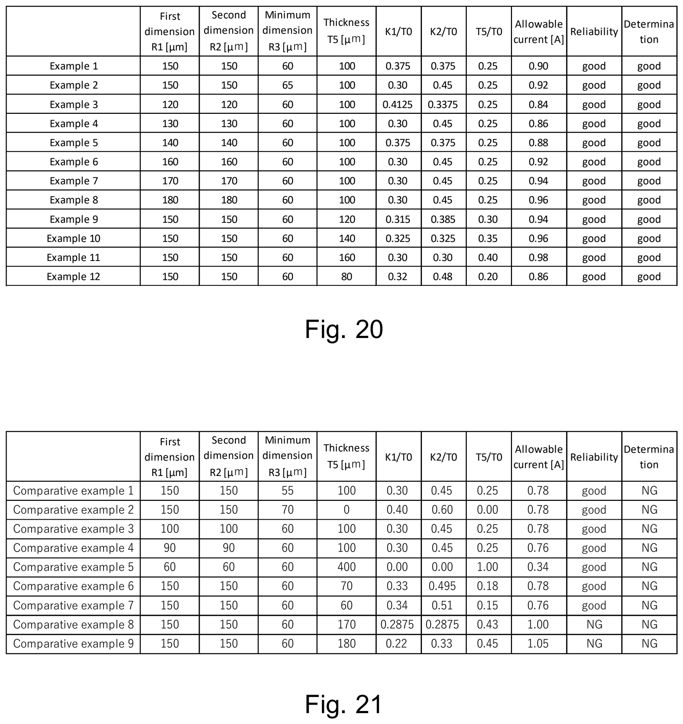

Any one of the values of the first dimension R1, the second dimension R2, and the minimum dimension R3 of each through hole 15, the first distance K1, the second distance K2, and the thickness T5 of each through via 20 was changed from that in the example 1, and the through-via substrate 10 was manufactured. Subsequently, the allowable current of the through-via substrate 10 was measured, and the reliability of the through-via substrate 10 was evaluated as in the case of the example 1. The result is illustrated in Fig. 20.

(COMPARATIVE EXAMPLES 1 to 9)

Any one of the values of the first dimension R1, the second dimension R2, and the minimum dimension R3 of each through hole 15, the first distance K1, the second distance K2, and the thickness T5 of each through via 20 was changed from that in the example 1, and a through-via substrate 10 was manufactured. Subsequently, the allowable current of the through-via substrate 10 was measured, and the reliability of the through-via substrate 10 was evaluated as in the case of the example 1. The result is illustrated in Fig. 21.

In Fig. 20 and Fig. 21, "good" in the column of "Reliability" means that the appearance of the through-via substrate 10 did not have a defect such as a crack after the thermal cycles. "NG" in the column of "Reliability" means that the appearance of the through-via substrate 10 had a defect such as a crack after the thermal cycles.

In Fig. 20 and Fig. 21, "good" in the column of "Determination" means that the allowable current was 0.80 A or more, and the result of evaluation of the reliability was "good". "NG" in the column of "Determination" means that the allowable current was less than 0.80 A, or the result of evaluation of the reliability was "NG".

As seen from the comparative example 1, in the case where the minimum dimension of the minimum portion 163 was 55 μm or less, the volume of each through via 20 was not sufficient, and the allowable current was less than 0.80 A. As seen from the comparative example 2, in the case where the minimum dimension of the minimum portion 163 was 70 μm or more, the closed portion 25 was not formed at the minimum portion 163, and the allowable current was less than 0.80 A. In the examples 1 to 12, the minimum dimension of the minimum portion 163 was more than 55 μm and less than 70 μm, and accordingly, the allowable current was 0.80 A or more.

As seen from the comparative examples 3 to 5, in the case where the first dimension R1 and the second dimension R2 of each through hole 15 were 100 μm or less, the volume of each through via 20 was not sufficient, and the allowable current was less than 0.80 A. In the examples 1 to 12, the first dimension R1 and the second dimension R2 of each through hole 15 were more than 100 μm, and accordingly, the allowable current was 0.80 A or more.

As seen from the comparative examples 6 to 7, in the case where the thickness T5 of the closed portion 25 was 70 μm or less, the volume of each through via 20 was not sufficient, and the allowable current was less than 0.80 A. In the examples 1 to 12, the thickness T5 of the closed portion 25 was more than 70 μm, and accordingly, the allowable current was 0.80 A or more.

As seen from the comparative examples 8 to 9, in the case where the thickness T5 of the closed portion 25 was 170 μm or more, the volume of each through via 20 was too high, and the appearance of the through-via substrate 10 had a defect such as a crack. In the examples 1 to 12, the thickness T5 of the closed portion 25 was less than 170 μm, and accordingly, a defect such as a crack was inhibited from occurring.

(EXAMPLES 13 to 17)

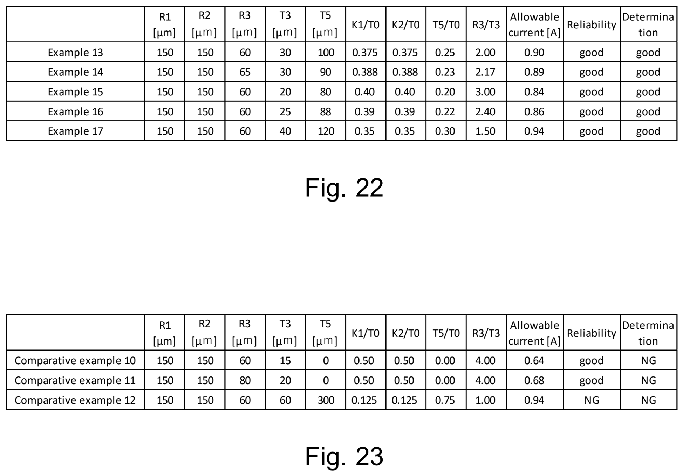

Any one of the values of the minimum dimension R3 of each through hole 15 and the thickness T3 or the thickness T5 of each through via 20 was changed from that in the example 1, and the through-via substrate 10 was manufactured. Subsequently, the allowable current of the through-via substrate 10 was measured, and the reliability of the through-via substrate 10 was evaluated as in the case of the example 1. The result is illustrated in Fig. 22.

(COMPARATIVE EXAMPLES 10 to 12)

Any one of the values of the minimum dimension R3 of each through hole 15 and the thickness T3 or the thickness T5 of each through via 20 was changed from that in the example 1, and a through-via substrate 10 was manufactured. Subsequently, the allowable current of the through-via substrate 10 was measured, and the reliability of the through-via substrate 10 was evaluated as in the case of the example 1. The result is illustrated in Fig. 23.

As seen from the comparative examples 10 and 11, in the case where R3/T3 that is the ratio of the minimum dimension R3 of each through hole 15 to the thickness T3 of the third portion 23 of each through via 20 was 4.00, the allowable current was less than 0.80 A. In the examples 13 to 17, R3/T3 was 1.2 or more, and accordingly, the allowable current was 0.80 A or more.

As seen from the comparative example 12, in the case where R3/T3 was 1.00, the appearance of the through-via substrate 10 had a defect such as a crack. In the examples 13 to 17, R3/T3 was 3.0 or less, and accordingly, a defect such as a crack was inhibited from occurring.

(COMPARATIVE EXAMPLE 13)

The through-via substrate illustrated in Fig. 12 was manufactured. The first dimension R1 and the second dimension R2 were 108 μm. The substrate 12 was a glass substrate that had a thickness T0 of 400 μm as in the example 1. Subsequently, the allowable current of a through-via substrate 10 was measured, and the reliability of the through-via substrate 10 was evaluated as in the case of the example 1. The allowable current was 1.1 A. The result of evaluation of the reliability was "NG".

In the comparative example 13 and the comparative examples 14 to 18 described later, the allowable current was calculated based on the result of a simulation for imitating the heat dissipation of the through-via substrate 10. The conditions of the simulation were as follows. In the simulation, a heat dissipation path was assumed such that heat that was generated by each through via 20 was dissipated from the first portion 21 of the through via 20 to the atmosphere through convective heat transfer.

· Thermal conductivity of substrate 12 : 1.4 [W/m·K]

· Thermal conductivity of through via 20 : 400 [W/m·K]

· Resistivity of through via 20 : $1.68 \times 10^{-8}$ [Ω·m]

· Thermal conductivity of resin layer 30 : 0.25 [W/m·K]

· Area of first portion 21 of through via 20 : 500 $\mu$m × 500 $\mu$m

· Thickness of first portion 21 of through via 20 : 18 [$\mu$m]

· Heat transfer coefficient between through via 20 and atmosphere : 373 [W/m$^2$·K]

A heat transfer coefficient of 373 [W/m$^2$·K] was calculated based on heat dissipation characteristics of a wiring substrate described in JIS C 5012:1993. The wiring substrate included a substrate composed of FR4 and a conductive layer that was located on the substrate. The structure of the wiring substrate was as follows.

· Thermal conductivity of substrate : 0.3 [W/m·K]

· Thickness of substrate : 400 $\mu$m

· Thermal conductivity of conductive layer : 400 [W/m·K]

· Resistivity of conductive layer : 1.68 × 10$^{-8}$ [Ω·m]

· Area of conductive layer : 500 $\mu$m × 500 $\mu$m

· Thickness of conductive layer : 18 [$\mu$m]

The target characteristics of the wiring substrate in the simulation were as follows. The heat transfer coefficient for achieving the target characteristics described later was 373 [W/m$^2$·K]. In the examples, a heat transfer coefficient of 373 [W/m$^2$·K] was used based on this result.

· Allowable current of conductive layer : 1 [A]
· Increase in temperature of conductive layer : 10 [°C]

(COMPARATIVE EXAMPLE 14)

The through-via substrate illustrated in Fig. 13 was manufactured. The first dimension R1 and the second dimension R2 were 85 $\mu$m and 50 $\mu$m. The substrate 12 was a glass substrate that had a thickness T0 of 400 $\mu$m as in the example 1. Subsequently, the allowable current of a through-via substrate 10 was measured, and the reliability of the through-via substrate 10 was evaluated as in the case of the example 1. The allowable current was 0.65 A. The result of evaluation of the reliability was "good".

(COMPARATIVE EXAMPLE 15)

The through-via substrate illustrated in Fig. 14 was manufactured. The first dimension R1 and the second dimension R2 were 108 $\mu$m. The thickness of the plating layer was 30 $\mu$m. The substrate 12 was a glass substrate that had a thickness T0 of 400 $\mu$m as in the example 1. Subsequently, the allowable current of a through-via substrate 10 was measured, and the reliability of the through-via substrate 10 was evaluated as in the case of the example 1. The allowable current was 1.1 A. The result of evaluation of the reliability was "NG".

(COMPARATIVE EXAMPLE 16)

The through-via substrate illustrated in Fig. 15 was manufactured. The first dimension R1 and the second dimension R2 were 85 $\mu$m and 50 $\mu$m. The thickness of the plating layer was 18 $\mu$m. The substrate 12 was a glass substrate that had a thickness T0 of 400 $\mu$m as in the example 1. Subsequently, the allowable current of a through-via substrate 10 was measured, and the reliability of the through-via substrate 10 was evaluated as in the case of the example 1. The allowable current was 0.60 A. The result of evaluation of the reliability was "good".

(COMPARATIVE EXAMPLE 17)

The through-via substrate illustrated in Fig. 16 was manufactured. The first dimension R1 and the second dimension R2 were 108 $\mu$m. The thickness of the plating layer was 30 $\mu$m. The substrate 12 was a glass substrate that had a thickness T0 of 400 $\mu$m as in the example 1. Subsequently, the allowable current of a through-via substrate 10 was measured, and the reliability of the through-via substrate 10 was evaluated as in the case of the example 1. The allowable current was 1.1 A. The result of evaluation of the reliability was "NG".

(COMPARATIVE EXAMPLE 18)

The through-via substrate illustrated in Fig. 17 was manufactured. The first dimension R1 and the second dimension R2 were 85 $\mu$m and 50 $\mu$m. The thickness of the plating layer was 18 $\mu$m. The substrate 12 was a glass substrate that had a thickness T0 of 400 $\mu$m as in the example 1. Subsequently, the allowable current of a through-via substrate 10 was measured, and the reliability of the through-via substrate 10 was evaluated as in the case of the example 1. The allowable current was 0.60 A. The result of evaluation of the reliability was "good".

(COMPARATIVE EXAMPLE A1)

A through-via substrate 10 was designed so as to include a copper plate that was located on a surface of the substrate 12 and the through via 20 that was illustrated in Fig. 12 and that was formed in the through hole 15 that did not include the minimum portion 163. The through via 20 illustrated in Fig. 12 is also referred to as a filled via. The substrate 12 was composed of FR4 and had a thickness T0 of 400 $\mu$m. The copper plate had a width of 0.5 mm and a thickness of 18 $\mu$m. Subsequently, a simulation for imitating the heat dissipation of the through-via substrate 10 was performed. In the simulation, a finite element method was used. In the simulation, it was assumed that heat was dissipated due to convection on a surface of the copper plate. An expression for heat flux is described below.

$$q = h\,(T_{Cu} - T_{air})$$

q is the heat flux. The unit of the heat flux q is W/m$^2$. h is thermal conductivity during convection. The unit of the thermal conductivity h is W/m$^2$·K. $T_{Cu}$ is the temperature of the copper plate. $T_{air}$ is the temperature of air. The value of the thermal conductivity h was 373 [W/m$^2$·K] as in the case of the comparative examples 13 to 18. The value was calculated based on the heat dissipation characteristics of the wiring substrate described in JIS C 5012:1993. Specifically, in a test described in JIS C 5012:1993, a copper plate that had a width of 0.6 mm and a thickness of 18 $\mu$m was disposed on a substrate, a direct current of 1 A was caused to flow into the copper plate, and consequently, the temperature increased by 10°C. If the result of the test was applied to the expression for the heat flux described above, the value of the thermal conductivity h that was calculated was 373 [W/m$^2$·K]. The other conditions in the simulation were as follows.

   · Thermal conductivity of copper : 400 [W/m·K]

   · Resistivity of copper : 1.68 $\times$ 10$^{-8}$ [$\Omega$·m]

   · Thermal conductivity of FR4 : 0.3 [W/m·K]

The first dimension R1 and the second dimension R2 when the through-via substrate 10 in the comparative example A1 satisfied a condition for current withstand capability were calculated based on the simulation. The condition for the current withstand capability was that "in the case where a direct current of 1 A flows into the through via 20, the temperature of the through via 20 increases by 10°C or less". The condition for the current withstand capability was stricter than a determination condition for the allowable current in Fig. 20 and Fig. 21 described above. A test in which an electric current was caused to flow into the through via 20, and the temperature was measured was conducted based on JIS C 5012:1993. The electric current flowed into the through via 20 until the temperature was stabilized.

In the case where the first dimension R1 and the second dimension R2 were 94 $\mu$m, the temperature increased by 10°C, and the value of the electric current that flowd into the copper plate and the filled via was 0.96 A. Accordingly, it was presumed that in the case where the first dimension R1 and the second dimension R2 were 94 $\mu$m or more, the condition for the current withstand capability described above was satisfied.

In the case where the first dimension R1 and the second dimension R2 were 94 $\mu$m, the value of the electric current that flowed into the copper plate and the filled via was 0.96 A, and the temperature of the through-via substrate 10 was 260°C, thermal stress that was applied between the substrate 12 and the filled via was calculated based on the simulation. At the first end 161 of the through hole 15, the thermal stress had a maximum value of 187 MPa.

(COMPARATIVE EXAMPLE A2)

A through-via substrate 10 was designed so as to include a copper plate that was located on a surface of the substrate 12 and the through via 20 that was illustrated in Fig. 14 and that was formed in the through hole 15 that did not include the minimum portion 163. The through via 20 illustrated in Fig. 14 is also referred to as a conformal via.

The first dimension R1, the second dimension R2, and the thickness of the through via 20 on the wall surface 16 when the through-via substrate 10 in the comparative example A2 satisfied the condition for the current withstand capability described above were calculated based on a simulation as in the case of the comparative example A1. In the case where the first dimension R1 and the second dimension R2 were 104 $\mu$m, and the thickness of the through via 20 on the wall surface 16 was 30 $\mu$m, the temperature increases by 10°C, and the value of the electric current that flowed into the copper plate and the conformal via was 0.97 A. Accordingly, it was presumed that in the case where the first dimension R1 and the second dimension R2 were 104 $\mu$m or more, and the thickness of the through via 20 on the wall surface 16 was 30 $\mu$m or more, the condition for the current withstand capability described above was satisfied.

In the case where the first dimension R1 and the second dimension R2 were 104 $\mu$m, the thickness of the through via 20 on the wall surface 16 was 30 $\mu$m, the value of the electric current that flowed into the copper plate and the conformal via was 0.97 A, and the temperature of the through-via substrate 10 was 260°C, thermal stress that was applied between the substrate 12 and the conformal via was calculated based on the simulation. At the first end 161 of the through hole 15, the thermal stress had a maximum value of 171 MPa.

(EXAMPLE A1)

A through-via substrate 10 was designed so as to include a copper plate that was located on a surface of the substrate 12 and the through via 20 that was illustrated in Fig. 4 and that was formed in the through hole 15 that included the minimum portion 163.

The first dimension R1, the second dimension R2, the minimum dimension R3, and the thicknesses of the third portion 23 and the fourth portion 24 when the through-via substrate 10 in the example A1 satisfied the condition for the current withstand capability described above were calculated based on a simulation as in the case of the comparative example A1. In the case where the first dimension R1 and the second dimension R2 were 180 μm, the minimum dimension R3 was 60 μm, the thickness T3 of the third portion 23 and the thickness T4 of the fourth portion 24 were 30 μm, the temperature increases by 10°C, and the value of the electric current that flowed into the copper plate and the through via 20 was 0.96 A. Accordingly, it was presumed that in the case where the first dimension R1 and the second dimension R2 were 180 μm or more, the minimum dimension R3 was 60 μm or more, the thickness T3 of the third portion 23 and the thickness T4 of the fourth portion 24 were 30 μm or more, the condition for the current withstand capability described above was satisfied.

In the case where the first dimension R1 and the second dimension R2 were 180 μm, the minimum dimension R3 was 60 μm, the thickness T3 of the third portion 23 and the thickness T4 of the fourth portion 24 were 30 μm, the value of the electric current that flowed into the copper plate and the through via 20 was 0.96 A, and the temperature of the through-via substrate 10 was 260°C, thermal stress that was applied between the substrate 12 and the through via 20 was calculated based on the simulation. At the first end 161 of the through hole 15, the thermal stress had a maximum value of 93 MPa.

The maximum value of the thermal stress in the example A1 was about half of the maximum value of the thermal stress in the comparative example A1 and the comparative example A2. It is thought that since the through hole 15 included the minimum portion 163 in the example A1, the angle θ1 and the angle θ2 were larger than 90°, and the thermal stress was reduced.

Reference Signs List

10 through-via substrate

12 substrate

13 first surface

14 second surface

15 through hole

16 wall surface

161 first end

162 second end

163 minimum portion

20 through via

201 plating layer

202 seed layer

21 first portion

22 second portion

23 third portion

24 fourth portion

25 closed portion

30 resin layer

31 first resin layer

32 second resin layer

35 first conductive layer

36 second conductive layer

41 first resist layer

42 second resist layer

**Claims**

1.  A through-via substrate comprising:

a substrate including a first surface, a second surface that is located opposite the first surface, and a through hole that extends from the first surface to the second surface; a through via that is partly located in the through hole; and a resin layer that is partly located in the through hole, wherein the through hole includes a wall surface including a first end that is connected to the first surface, a second end that is connected to the second surface, and a minimum portion that is located between the first end and the second end, wherein the through hole has a minimum dimension at the minimum portion, the minimum dimension being defined as a minimum value of a dimension of the through hole in a plane direction of the first surface, wherein the through via includes a closed portion that closes the through hole at least at the minimum portion, a third portion that is located on the wall surface between the first surface and the closed portion, and a fourth portion that is located on the wall surface between the second surface and the closed portion,

wherein the resin layer includes a first resin layer that is located inside the third portion and a second resin layer that is located inside the fourth portion,

wherein the through via has a first distance that is a maximum value of a distance from the first surface to the closed portion in a thickness direction of the substrate and a second distance that is a maximum value of a distance from the second surface to the closed portion in the thickness direction of the substrate,

wherein a ratio of the first distance to a thickness of the substrate is 0.10 or more, and

wherein a ratio of the second distance to the thickness of the substrate is 0.10 or more.

2. The through-via substrate according to claim 1, wherein the through via includes a first portion that is located on the first surface and that is connected to the third portion.

3. The through-via substrate according to claim 2, wherein the through via includes a second portion that is located on the second surface and that is connected to the fourth portion.

4. The through-via substrate according to claim 1, further comprising: a first surface resin layer that is located on the first surface,

wherein the first surface resin layer overlaps a boundary between the wall surface and the third portion in plan view.

5. The through-via substrate according to claim 4, further comprising: a second surface resin layer that is located on the second surface,

wherein the second surface resin layer overlaps a boundary between the wall surface and the fourth portion in plan view.

6. The through-via substrate according to claim 1, wherein a ratio of a thickness of the closed portion to the thickness of the substrate is 0.20 or more and 0.40 or less.

7. The through-via substrate according to claim 1, wherein the through hole has a first dimension at the first end and has a second dimension at the second end in the plane direction of the first surface,

   wherein a ratio of the first dimension to the minimum dimension is 2.0 or more, and
   wherein a ratio of the second dimension to the minimum dimension is 2.0 or more.

8. The through-via substrate according to claim 7, wherein the ratio of the first dimension to the minimum dimension is 3.0 or less, and

   wherein the ratio of the second dimension to the minimum dimension is 3.0 or less.

9. The through-via substrate according to claim 7 or claim 8, wherein a ratio of the second dimension to the first dimension is 0.80 or more and 1.20 or less.

10. The through-via substrate according to any one of claim 1 to claim 8, wherein a ratio of a distance from the first surface to the minimum portion in the thickness direction of the substrate to the thickness of the substrate is 0.40 or more and 0.60 or less.

11. The through-via substrate according to any one of claim 1 to claim 8, wherein the minimum dimension is 60 $\mu$m or more.

12. The through-via substrate according to any one of claim 1 to claim 8, wherein a ratio of the minimum dimension to a thickness of the third portion is 1.2 or more, and

    wherein a ratio of the minimum dimension to a thickness of the fourth portion is 1.2 or more.

13. The through-via substrate according to any one of claim 1 to claim 8, wherein a ratio of the minimum dimension to a thickness of the third portion is 3.0 or less, and

    wherein a ratio of the minimum dimension to a thickness of the fourth portion is 3.0 or less.

14. The through-via substrate according to any one of claim 1 to claim 8, wherein a thickness of the third portion and a thickness of the fourth portion are 20 $\mu$m or more.

15. The through-via substrate according to claim 14, wherein a variation in the thickness of the third portion is 0.10 $\mu$m or less.

16. The through-via substrate according to any one of claim 1 to claim 8, wherein the through via includes a seed layer and a plating layer that is located on the seed layer.

17. The through-via substrate according to claim 16, wherein the plating layer contains copper.

18. A mounting substrate comprising: the through-via substrate according to any one of claim 1 to claim 8; and

    an element that is electrically connected to the through via of the through-via substrate.

19. A method of manufacturing a through-via substrate, the method comprising:

a step of preparing a substrate including a first surface, a second surface that is located opposite the first surface, and a through hole that extends from the first surface to the second surface;

a through via formation step of partly forming a through via in the through hole; and

a resin layer formation step of partly forming a resin layer in the through hole,

wherein the through hole includes a wall surface including a first end that is connected to the first surface, a second end that is connected to the second surface, and a minimum portion that is located between the first end and the second end,

wherein the through hole has a minimum dimension at the minimum portion, the minimum dimension being defined as a minimum value of a dimension of the through hole in a plane direction of the first surface,

wherein the through via formation step includes a step of forming a seed layer on the wall surface of the through hole and a plating step of forming a plating layer on the seed layer,

wherein the plating step includes a first plating step of forming a closed portion that closes the through hole at least at the minimum portion and a second plating step of growing the closed portion in a thickness direction of the substrate,

wherein the through via has a first distance that is a maximum value of a distance from the first surface to the closed portion in the thickness direction of the substrate and a second distance that is a maximum value of a distance from the second surface to the closed portion in the thickness direction of the substrate, and

wherein the second plating step ends in a state in which a ratio of the first distance to a thickness of the substrate is 0.10 or more, and a ratio of the second distance to the thickness of the substrate is 0.10 or more.

20. The method according to claim 19, wherein the second plating step is performed such that a ratio of a thickness of the closed portion to the thickness of the substrate is 0.20 or more and 0.40 or less.

Fig. 1

Fig. 2

Fig. 3

Fig. 4

Fig. 5

Fig. 6

Fig. 7

Fig. 8

Fig. 9

Fig. 10

Fig. 11

R1

161          20

16                    13

15              12

14

162

R2

## Fig. 12

R1

161          20

16

15

162

R2

## Fig. 13

Fig. 14

Fig. 15

Fig. 16

Fig. 17

Fig. 18

110

120

130

140

150

160

170

180

Fig. 19

| | First dimension R1 [μm] | Second dimension R2 [μm] | Minimum dimension R3 [μm] | Thickness T5 [μm] | K1/T0 | K2/T0 | T5/T0 | Allowable current [A] | Reliability | Determination |
|---|---|---|---|---|---|---|---|---|---|---|
| Example 1 | 150 | 150 | 60 | 100 | 0.375 | 0.375 | 0.25 | 0.90 | good | good |
| Example 2 | 150 | 150 | 65 | 100 | 0.30 | 0.45 | 0.25 | 0.92 | good | good |
| Example 3 | 120 | 120 | 60 | 100 | 0.4125 | 0.3375 | 0.25 | 0.84 | good | good |
| Example 4 | 130 | 130 | 60 | 100 | 0.30 | 0.45 | 0.25 | 0.86 | good | good |
| Example 5 | 140 | 140 | 60 | 100 | 0.375 | 0.375 | 0.25 | 0.88 | good | good |
| Example 6 | 160 | 160 | 60 | 100 | 0.30 | 0.45 | 0.25 | 0.92 | good | good |
| Example 7 | 170 | 170 | 60 | 100 | 0.30 | 0.45 | 0.25 | 0.94 | good | good |
| Example 8 | 180 | 180 | 60 | 100 | 0.30 | 0.45 | 0.25 | 0.96 | good | good |
| Example 9 | 150 | 150 | 60 | 120 | 0.315 | 0.385 | 0.30 | 0.94 | good | good |
| Example 10 | 150 | 150 | 60 | 140 | 0.325 | 0.325 | 0.35 | 0.96 | good | good |
| Example 11 | 150 | 150 | 60 | 160 | 0.30 | 0.30 | 0.40 | 0.98 | good | good |
| Example 12 | 150 | 150 | 60 | 80 | 0.32 | 0.48 | 0.20 | 0.86 | good | good |

Fig. 20

| | First dimension R1 [μm] | Second dimension R2 [μm] | Minimum dimension R3 [μm] | Thickness T5 [μm] | K1/T0 | K2/T0 | T5/T0 | Allowable current [A] | Reliability | Determination |
|---|---|---|---|---|---|---|---|---|---|---|
| Comparative example 1 | 150 | 150 | 55 | 100 | 0.30 | 0.45 | 0.25 | 0.78 | good | NG |
| Comparative example 2 | 150 | 150 | 70 | 0 | 0.40 | 0.60 | 0.00 | 0.78 | good | NG |
| Comparative example 3 | 100 | 100 | 60 | 100 | 0.30 | 0.45 | 0.25 | 0.78 | good | NG |
| Comparative example 4 | 90 | 90 | 60 | 100 | 0.30 | 0.45 | 0.25 | 0.76 | good | NG |
| Comparative example 5 | 60 | 60 | 60 | 400 | 0.00 | 0.00 | 1.00 | 0.34 | good | NG |
| Comparative example 6 | 150 | 150 | 60 | 70 | 0.33 | 0.495 | 0.18 | 0.78 | good | NG |
| Comparative example 7 | 150 | 150 | 60 | 60 | 0.34 | 0.51 | 0.15 | 0.76 | good | NG |
| Comparative example 8 | 150 | 150 | 60 | 170 | 0.2875 | 0.2875 | 0.43 | 1.00 | NG | NG |
| Comparative example 9 | 150 | 150 | 60 | 180 | 0.22 | 0.33 | 0.45 | 1.05 | NG | NG |

Fig. 21

| | R1 [μm] | R2 [μm] | R3 [μm] | T3 [μm] | T5 [μm] | K1/T0 | K2/T0 | T5/T0 | R3/T3 | Allowable current [A] | Reliability | Determination |
|---|---|---|---|---|---|---|---|---|---|---|---|---|
| Example 13 | 150 | 150 | 60 | 30 | 100 | 0.375 | 0.375 | 0.25 | 2.00 | 0.90 | good | good |
| Example 14 | 150 | 150 | 65 | 30 | 90 | 0.388 | 0.388 | 0.23 | 2.17 | 0.89 | good | good |
| Example 15 | 150 | 150 | 60 | 20 | 80 | 0.40 | 0.40 | 0.20 | 3.00 | 0.84 | good | good |
| Example 16 | 150 | 150 | 60 | 25 | 88 | 0.39 | 0.39 | 0.22 | 2.40 | 0.86 | good | good |
| Example 17 | 150 | 150 | 60 | 40 | 120 | 0.35 | 0.35 | 0.30 | 1.50 | 0.94 | good | good |

# Fig. 22

| | R1 [μm] | R2 [μm] | R3 [μm] | T3 [μm] | T5 [μm] | K1/T0 | K2/T0 | T5/T0 | R3/T3 | Allowable current [A] | Reliability | Determination |
|---|---|---|---|---|---|---|---|---|---|---|---|---|
| Comparative example 10 | 150 | 150 | 60 | 15 | 0 | 0.50 | 0.50 | 0.00 | 4.00 | 0.64 | good | NG |
| Comparative example 11 | 150 | 150 | 80 | 20 | 0 | 0.50 | 0.50 | 0.00 | 4.00 | 0.68 | good | NG |
| Comparative example 12 | 150 | 150 | 60 | 60 | 300 | 0.125 | 0.125 | 0.75 | 1.00 | 0.94 | NG | NG |

# Fig. 23

Fig. 24

Fig. 25

Fig. 26

Fig. 27

Fig. 28

Fig. 29

Fig. 30

Fig. 31

Fig. 32

Fig. 33

Fig. 34

Fig. 35

Fig. 36

Fig. 37

Fig. 38

Fig. 39

## INTERNATIONAL SEARCH REPORT

| | International application No. |
|---|---|
| | **PCT/JP2024/020939** |

**A. CLASSIFICATION OF SUBJECT MATTER**

*H05K 1/11*(2006.01)i; *H05K 1/02*(2006.01)i; *H05K 3/40*(2006.01)i; *H05K 3/42*(2006.01)i
FI:   H05K1/11 H; H05K3/42 610B; H05K1/11 N; H05K1/02 C; H05K1/02 J; H05K3/40 E

According to International Patent Classification (IPC) or to both national classification and IPC

**B. FIELDS SEARCHED**

Minimum documentation searched (classification system followed by classification symbols)

H05K1/11; H05K1/02; H05K3/40; H05K3/42

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/173057 A1 (DAI NIPPON PRINTING CO., LTD.) 18 August 2022 (2022-08-18) | 1-20 |
| A | JP 2006-310779 A (KYOCERA CORPORATION) 09 November 2006 (2006-11-09) | 1-20 |
| A | JP 2020-88192 A (SHINKO ELECTRIC INDUSTRIES CO., LTD.) 04 June 2020 (2020-06-04) | 1-20 |
| A | EP 3570645 A1 (AT & S AUSTRIA TECHNOLOGIE & SYSTEMTECHNIK AKTIENGESELLSCHAFT) 20 November 2019 (2019-11-20) | 1-20 |
| A | US 2013/0118784 A1 (INVENSAS CORPORATION) 16 May 2013 (2013-05-16) | 1-20 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 August 2024** | **20 August 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/020939**

| Patent document cited in search report | | | Publication date (day/month/year) | Patent family member(s) | | | Publication date (day/month/year) |
|---|---|---|---|---|---|---|---|
| WO | 2022/173057 | A1 | 18 August 2022 | CN | 117063620 | A | |
| | | | | KR | 10-2023-0146557 | A | |
| | | | | TW | 202247725 | A | |
| JP | 2006-310779 | A | 09 November 2006 | (Family: none) | | | |
| JP | 2020-88192 | A | 04 June 2020 | US | 2020/0168541 | A1 | |
| EP | 3570645 | A1 | 20 November 2019 | (Family: none) | | | |
| US | 2013/0118784 | A1 | 16 May 2013 | (Family: none) | | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022173057 A